# EUROPEAN PATENT APPLICATION

(11) **EP 4 387 421 A2**
(43) Date of publication of application: **19.06.2024**
(21) Application number: 23216680.1
(22) Date of filing: 14.12.2023
(51) Int. Cl.: H10K 59/121, H10K 59/131

(54) **DISPLAY DEVICE**

(30) Priority: 16.12.2022 KR 20220176532
(71) Applicant: LG Display Co., Ltd., Seoul 07336 (KR)
(72) Inventor: Lee, Jinuk, 10845 Paju-si (KR); Yoon, Jungseop, 10845 Paju-si (KR)
(74) Representative: Ter Meer Steinmeister & Partner

(57) **Abstract**

A display device may include a substrate, a display area having a plurality of pixels, a sensor hole area, a sensor non-display area disposed between the display area and the sensor hole area, a first conductive layer disposed on the substrate and including a scan wiring connected to the plurality of pixels and extending along a first direction, a second conductive layer disposed on the first conductive layer, and a high voltage power wiring connected to the plurality of pixels. At least a portion of the high voltage power wiring may be disposed in the second conductive layer, and the high voltage power wiring may include a hole-surrounding high voltage power wiring surrounding the sensor non-display area on a plane.

## Description

This application claims the benefit of and priority to Korean Patent Application No. 10-2022-0176532, filed December 16, 2022.

### BACKGROUND

### 1. Technical Field

The present disclosure relates to a display device.

### 2. Discussion of the Related Art

An organic light-emitting display device includes organic light-emitting diodes including hole injection electrodes, organic light-emitting layers, and electron injection electrodes. Each organic light-emitting diode emits light based on energy generated when an exciton generated by a combination of an electron and a hole in the organic light-emitting layer falls from an excited state to a ground state, and the organic light-emitting display device displays a predetermined image based on such light emission.

The organic light-emitting display device has self-luminance characteristics, and is slim and lightweight because a light source is not separately required unlike a liquid crystal display device. Further, the organic light-emitting display device has attracted attention as the next-generation display device with high-quality characteristics such as low power consumption, high brightness, and quick response speed.

Meanwhile, the organic light-emitting display device requires a process of encapsulating pixels with a glass substrate or the like to protect the pixels. However, due to the thickness and weight of the glass substrate, technologies are currently being developed to form a thin film encapsulation (TFE) layer by alternately stacking inorganic films and organic films as one or more layers.

The description provided in the discussion of the related art section should not be assumed to be prior art merely because it is mentioned in or associated with that section. The discussion of the related art section may include information that describes one or more aspects of the subject technology, and the description in this section does not limit the invention.

### SUMMARY

One object of the present disclosure is to provide a display device with improved stability in supplying high voltage power.

The problem is solved by the features of the independent claim. The problems to be solved are not limited to those mentioned above, and other technical problems are described or will become apparent to those skilled in the art from the present disclosure.

According to an aspect of the disclosure, a display device includes: a substrate; a display area including a plurality of pixels; a sensor hole area; a sensor non-display area disposed between the display area and the sensor hole area; a first conductive layer disposed on the substrate and including a scan wiring connected to the plurality of pixels and extending along a first direction; a second conductive layer disposed on the first conductive layer; and a high voltage power wiring connected to the plurality of pixels. The high voltage power wiring may include a hole-surrounding high voltage power wiring surrounding the sensor non-display area on a plane. At least a portion of the hole-surrounding high voltage power wiring may be disposed in the second conductive layer.

According to an aspect of the disclosure, a display device includes: a substrate; a display area including a plurality of pixels; a sensor hole area; a sensor non-display area disposed between the display area and the sensor hole area; a first conductive layer disposed on the substrate and including a scan wiring connected to the plurality of pixels and extending along a first direction; a second conductive layer disposed on the first conductive layer; and a third conductive layer disposed on the second conductive layer, connected to the plurality of pixels, and including a data wiring extending along the second direction intersecting the first direction. The display device may further include a high voltage power wiring connected to the plurality of pixels. The high voltage power wiring may include a hole-surrounding high voltage power wiring surrounding the sensor non-display area on a plane. The hole-surrounding high voltage power wiring may include two or more layers.

According to an aspect of the disclosure, a display device may include: a substrate; a display area including a plurality of pixels; a hole area; a non-display area disposed between the display area and the hole area; a conductive layer disposed on the substrate; and a power wiring connected to the plurality of pixels and configured to provide power. At least a portion of the power wiring may be disposed in the conductive layer. The power wiring may include a hole-surrounding power wiring surrounding the non-display area.

The display device according to any one of these aspects may include one or more of the following features:

The scan wiring may include or be a plurality of scan lines. The data wiring may include or be a plurality of data lines. The high voltage power wiring may include or be a plurality of high voltage power lines.

The high voltage power wiring may further comprise a first high voltage power wiring extending along a second direction intersecting the first direction.

The hole-surrounding high voltage power wiring has a larger width than the first high voltage power wiring.

The high voltage power wiring may be disposed outside the sensor non-display area and/or may not overlap the sensor non-display area.

The scan wiring may extend along the first direction and/or bypass the sensor hole area on a plane within the sensor non-display area.

The high voltage power wiring may further comprise an upper high voltage power wiring and a lower high voltage power wiring. The high voltage power wiring may further comprise an upper high voltage power wiring disposed at an upper side of the hole-surrounding high voltage power wiring on a plane and/or connected to the hole-surrounding high voltage power wiring. The high voltage power wiring may further comprise a lower high voltage power wiring disposed at a lower side of the hole-surrounding high voltage power wiring on a plane and/or connected to the hole-surrounding high voltage power wiring.

The upper high voltage power wiring and the lower high voltage power wiring may extend along a second direction intersecting the first direction.

The scan wiring may intersect the hole-surrounding high voltage power wiring on a plane.

A third conductive layer may be disposed on the second conductive layer. The third conductive layer may comprise a data wiring connected to the plurality of pixels.

The hole-surrounding high voltage power wiring may comprise a first hole-surrounding high voltage power wiring portion and a second hole-surrounding high voltage power wiring portion spaced apart from each other with the scan wiring disposed between the first and second hole-surrounding high voltage power wiring portions on a plane.

The hole-surrounding high voltage power wiring may further comprise a connection high voltage power wiring portion disposed in the third conductive layer. The connection high voltage power wiring portion may be connected to the first hole-surrounding high voltage power wiring portion and the second hole-surrounding high voltage power wiring portion.

The connection high voltage power wiring portion may intersect the scan wiring on a plane.

The hole-surrounding high voltage power wiring may comprise a first hole-surrounding high voltage power wiring disposed in the first conductive layer, and/or a second hole-surrounding high voltage power wiring disposed in the second conductive layer.

The first hole-surrounding high voltage power wiring may comprise a first hole-surrounding high voltage power wiring portion and a second hole-surrounding high voltage power wiring portion spaced apart from each other with the scan wiring between the first and second hole-surrounding high voltage power wiring portions on a plane. The first hole-surrounding high voltage power wiring portion and the second hole-surrounding high voltage power wiring portion may be electrically connected.

A second conductive layer may be disposed on the substrate and/or comprise a first signal wiring.

The second conductive layer may be different from the conductive layer.

At least a portion of the hole-surrounding power wiring may overlap with at least a portion of the first signal wiring.

A third conductive layer may be disposed on the substrate and/or comprise a second signal wiring.

The third conductive layer may be different from the second conductive layer and different from the conductive layer.

At least a portion of the hole-surrounding power wiring may overlap with at least a portion of the second signal wiring in the display area.

At least a portion of the first signal wiring and/or at least a portion of the second signal wiring may be disposed in the non-display area. At least a portion of the first signal wiring and/or at least a portion of the second signal wiring may surround the hole area. At least a portion of the first signal wiring and/or at least a portion of the second signal wiring may be surrounded by the hole-surrounding power wiring.

At least a part of the hole-surrounding power wiring may be disposed in at least one of the second conductive layer and the third conductive layer.

The hole-surrounding power wiring may expose, i.e. may not be disposed, in the non-display area.

The hole-surrounding power wiring may surround the hole area.

The hole-surrounding power wiring may expose, i.e. may not be disposed, in the hole area.

The first and second directions may be perpendicular to each other.

Details of one or more other example embodiments are included in the detailed description and the accompanying drawings.

By the display device according to one or more example embodiments, the supply of high voltage power is improved in stability.

Further, in one or more example embodiments, a hole-surrounding high voltage power wiring may include a connection high voltage power wiring portion at an intersection between the hole-surrounding high voltage power wiring and the scan wiring, thereby preventing a short circuit between the scan wiring and the hole-surrounding high voltage power wiring.

The effects of the embodiments are not limited by the foregoing, and other various effects are described or will become apparent to those skilled in the art from the present disclosure.

Other devices, methods, features and advantages will be, or will become, apparent to one with skill in the art upon examination of the drawings and detailed description herein. It is intended that all such devices, methods, features and advantages be included within this description, be within the scope of the present disclosure, and be protected by the following claims. Nothing in this section should be taken as a limitation on the claims. Further aspects and advantages are discussed below in conjunction with embodiments of the disclosure.

It is to be understood that both the foregoing description and the following description of the present disclosure are examples, and are intended to provide further explanation of the disclosure as claimed.

### BRIEF DESCRIPTION OF THE DRAWINGS

The accompanying drawings, which are included to provide a further understanding of the disclosure, are incorporated in and constitute a part of this disclosure, illustrate aspects and embodiments of the disclosure, and together with the description serve to explain principles and examples of the disclosure.
FIG. 1 is a plan view of a display device according to an example embodiment.
FIG. 2 is a plan view showing an example of high voltage power wirings, data wirings, and scan wirings of the display device of FIG. 1 in detail.
FIG. 3 is an example of a cross-sectional view taken along lines I-I' and II-II' in FIG. 1.
FIG. 4 is an example of an enlarged plan view of an area A in FIG. 2.
FIG. 5 is an example of an enlarged plan view of an area B in FIG. 4.
FIG. 6 is an example of a cross-sectional view taken along lines III-III' and IV-IV' in FIG. 5.
FIG. 7 is a plan view of a display device according to another example embodiment.
FIG. 8 is a plan view of a display device according to yet another example embodiment.
FIG. 9 is an example of a cross-sectional view taken along lines III-III' and IV-IV' in FIG. 8.
FIG. 10 is a plan view of a display device according to yet another example embodiment.
FIG. 11 is a plan view of a display device according to yet another example embodiment.
FIG. 12 is an example of a cross-sectional view taken along lines III-III' and IV-IV' in FIG. 11.
FIG. 13 is a plan view of a display device according to yet another example embodiment.
FIG. 14 is a plan view of a display device according to yet another example embodiment.
FIG. 15 is a plan view of a display device according to yet another example embodiment.

Throughout the drawings and the detailed description, unless otherwise described, the same drawing reference numerals should be understood to refer to the same elements, features, and structures. The sizes, lengths, and thicknesses of layers, regions and elements, and depiction thereof may be exaggerated for clarity, illustration, and convenience.

### DETAILED DESCRIPTION

Reference is now made in detail to embodiments of the present disclosure, examples of which may be illustrated in the accompanying drawings. In the following description, when a detailed description of well-known methods, functions, structures or configurations may unnecessarily obscure aspects of the present disclosure, the detailed description thereof may have been omitted for brevity. Further, repetitive descriptions may be omitted for brevity. The progression of processing steps and/or operations described is a non-limiting example.

The sequence of steps and/or operations is not limited to that set forth herein and may be changed to occur in an order that is different from an order described herein, with the exception of steps and/or operations necessarily occurring in a particular order. In one or more examples, two operations in succession may be performed substantially concurrently, or the two operations may be performed in a reverse order or in a different order depending on a function or operation involved.

Unless stated otherwise, like reference numerals may refer to like elements throughout even when they are shown in different drawings. In one or more aspects, identical elements (or elements with identical names) in different drawings may have the same or substantially the same functions and properties unless stated otherwise. Names of the respective elements used in the following explanations are selected only for convenience and may be thus different from those used in actual products.

Advantages and features of the present disclosure, and implementation methods thereof, are clarified through the embodiments described with reference to the accompanying drawings. The present disclosure may, however, be embodied in different forms and should not be construed as limited to the embodiments set forth herein. Rather, these embodiments are examples and are provided so that this disclosure may be thorough and complete to assist those skilled in the art to understand the inventive concepts without limiting the protected scope of the present disclosure. Further, the present disclosure is defined by the scope of claims and their equivalents.

Shapes, dimensions (e.g., sizes, lengths, widths, heights, thicknesses, locations, radii, diameters, and areas), proportions, ratios, angles, numbers, the number of elements, and the like disclosed herein, including those illustrated in the drawings, are merely examples, and thus, the present disclosure is not limited to the illustrated details. It is, however, noted that the relative dimensions of the components illustrated in the drawings are part of the present disclosure.

When the term "comprise," "have," "include," "contain," "constitute," "made of," "formed of," "composed of," or the like is used with respect to one or more elements, one or more other elements may be added unless a term such as "only" or the like is used. The terms used in the present disclosure are merely used in order to describe particular example embodiments, and are not intended to limit the scope of the present disclosure. The terms of a singular form may include plural forms unless the context clearly indicates otherwise. The word "exemplary" is used to mean serving as an example or illustration. Embodiments are example embodiments. Aspects are example aspects. "Embodiments," "examples," "aspects," and the like should not be construed to be preferred or advantageous over other implementations. An embodiment, an example, an example embodiment, an aspect, or the like may refer to one or more embodiments, one or more examples, one or more example embodiments, one or more aspects, or the like, unless stated otherwise. Further, the term "may" encompasses all the meanings of the term "can."

In one or more aspects, unless explicitly stated otherwise, an element, feature, or corresponding information (e.g., a level, range, dimension, size, or the like) is construed to include an error or tolerance range even where no explicit description of such an error or tolerance range is provided. An error or tolerance range may be caused by various factors (e.g., process factors, internal or external impact, noise, or the like). In interpreting a numerical value, the value is interpreted as including an error range unless explicitly stated otherwise.

In describing a positional relationship, where the positional relationship between two elements (e.g., layers, films, regions, components, sections, or the like) is described, for example, using "on," "upon," "on top of," "over," "under," "above," "below," "beneath," "near," "close to," "adjacent to," "beside," "next to," "at or on a side of " or the like, one or more other elements may be located between the two elements unless a more limiting term, such as "immediate(ly)," "direct(ly)," or "close(ly)," is used. For example, when an element is described as being positioned "on," "on a top of," "upon," "on top of," "over," "under," "above," "below," "beneath," "near," "close to," "adjacent to," "beside," "next to," or "at or on a side of " another element, this description should be construed as including a case in which the elements contact each other directly as well as a case in which one or more additional elements are disposed or interposed therebetween. Furthermore, the terms "front," "rear," "back," "left," "right," "top," "bottom," "downward," "upward," "upper," "lower," "up," "down," "column," "row," "vertical," "horizontal," and the like refer to an arbitrary frame of reference.

Spatially relative terms, such as "below," "beneath," "lower," "on," "above," "upper" and the like, can be used to describe a correlation between various elements (e.g., layers, films, regions, components, sections, or the like) as shown in the drawings. The spatially relative terms are to be understood as terms including different orientations of the elements in use or in operation in addition to the orientation depicted in the drawings. For example, if the elements shown in the drawings are turned over, elements described as "below" or "beneath" other elements would be oriented "above" other elements. Thus, the term "below," which is an example term, can include all directions of "above" and "below." Likewise, an exemplary term "above" or "on" can include both directions of "above" and "below."

In describing a temporal relationship, when the temporal order is described as, for example, "after," "subsequent," "next," "before," "preceding," "prior to," or the like, a case that is not consecutive or not sequential may be included and thus one or more other events may occur therebetween, unless a more limiting term, such as "just," "immediate(ly)," or "direct(ly)," is used.

It is understood that, although the terms "first," "second," and the like may be used herein to describe various elements (e.g., layers, films, regions, components, sections, or the like), these elements should not be limited by these terms, for example, to any particular order, precedence, or number of elements. These terms are used only to distinguish one element from another. For example, a first element could be a second element, and, similarly, a second element could be a first element, without departing from the scope of the present disclosure. Furthermore, the first element, the second element, and the like may be arbitrarily named according to the convenience of those skilled in the art without departing from the scope of the present disclosure. For clarity, the functions or structures of these elements (e.g., the first element, the second element, and the like) are not limited by ordinal numbers or the names in front of the elements. Further, a first element may include one or more first elements. Similarly, a second element or the like may include one or more second elements or the like.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element (e.g., layer, film, region, component, section, or the like) is "connected," "coupled," "attached," "adhered," or the like to another element, the element can not only be directly connected, coupled, attached, adhered, or the like to another element, but also be indirectly connected, coupled, attached, adhered, or the like to another element with one or more intervening elements disposed or interposed between the elements, unless otherwise specified.

For the expression that an element (e.g., layer, film, region, component, section, or the like) "contacts," "overlaps," or the like with another element, the element can not only directly contact, overlap, or the like with another element, but also indirectly contact, overlap, or the like with another element with one or more intervening elements disposed or interposed between the elements, unless otherwise specified.

The phase that an element (e.g., layer, film, region, component, section, or the like) is "provided in," "disposed in," or the like in another element may be understood as that at least a portion of the element is provided in, disposed in, or the like in another element, or that the entirety of the element is provided in, disposed in, or the like in another element. The phrase "through" may be understood to be at least partially through or entirely through. The phase that an element (e.g., layer, film, region, component, section, or the like) "contacts," "overlaps," or the like with another element may be understood as that at least a portion of the element contacts, overlaps, or the like with a least a portion of another element, that the entirety of the element contacts, overlaps, or the like with a least a portion of another element, or that at least a portion of the element contacts, overlaps, or the like with the entirety of another element.

The terms such as a "line" or "direction" should not be interpreted only based on a geometrical relationship in which the respective lines or directions are parallel or perpendicular to each other, and may be meant as lines or directions having wider directivities within the range within which the components of the present disclosure can operate functionally.

The term "at least one" should be understood as including any and all combinations of one or more of the associated listed items. For example, each of the phrases "at least one of a first item, a second item, or a third item" and "at least one of a first item, a second item, and a third item" may represent (i) a combination of items provided by two or more of the first item, the second item, and the third item or (ii) only one of the first item, the second item, or the third item. Further, at least one of a plurality of elements can represent (i) one element of the plurality of elements, (ii) some elements of the plurality of elements, or (iii) all elements of the plurality of elements. Further, one or more of a plurality of elements can represent (i) one element of the plurality of elements, (ii) some elements of the plurality of elements, or (iii) all elements of the plurality of elements. Further, some elements of the plurality of elements can represent (i) one element of the plurality of elements or (ii) more than one element of the plurality of elements. Further, at least a part of a plurality of elements can represent (i) a part of the plurality of elements, (ii) one or more of the plurality of elements, or (iii) at least parts (or portions) of the plurality of elements. Moreover, at least a portion (or a part) of an element can represent (i) a portion (or a part) of the element, (ii) one or more portions (or parts) of the element, or (iii) the element.

The expression of a first element, a second elements "and/or" a third element should be understood as one of the first, second and third elements or as any or all combinations of the first, second and third elements. By way of example, A, B and/or C may refer to only A; only B; only C; any of A, B, and C (e.g., A, B, or C); some combination of A, B, and C (e.g., A and B; A and C; or B and C); or all of A, B, and C. Furthermore, an expression "A/B" may be understood as A and/or B. For example, an expression "A/B" may refer to only A; only B; A or B; or A and B.

In one or more aspects, the terms "between" and "among" may be used interchangeably simply for convenience unless stated otherwise. For example, an expression "between a plurality of elements" may be understood as among a plurality of elements. In another example, an expression "among a plurality of elements" may be understood as between a plurality of elements. In one or more examples, the number of elements may be two. In one or more examples, the number of elements may be more than two. Furthermore, when an element (e.g., layer, film, region, component, section, or the like) is referred to as being "between" at least two elements, the element may be the only element between the at least two elements, or one or more intervening elements may also be present.

In one or more aspects, the phrases "each other" and "one another" may be used interchangeably simply for convenience unless stated otherwise. For example, an expression "different from each other" may be understood as being different from one another. In another example, an expression "different from one another" may be understood as being different from each other. In one or more examples, the number of elements involved in the foregoing expression may be two. In one or more examples, the number of elements involved in the foregoing expression may be more than two.

In one or more aspects, the phrases "one or more among" and "one or more of' may be used interchangeably simply for convenience unless stated otherwise.

The term "or" means "inclusive or" rather than "exclusive or." That is, unless otherwise stated or clear from the context, the expression that "x uses a or b" means any one of natural inclusive permutations. For example, "a or b" may mean "a," "b," or "a and b." For example, "a, b or c" may mean "a," "b," "c," "a and b," "b and c," "a and c," or "a, b and c."

Features of various embodiments of the present disclosure may be partially or entirely coupled to or combined with each other, may be technically associated with each other, and may be variously operated, linked or driven together in various ways. Embodiments of the present disclosure may be implemented or carried out independently of each other or may be implemented or carried out together in a co-dependent or related relationship. In one or more aspects, the components of each apparatus and device according to various embodiments of the present disclosure are operatively coupled and configured.

Unless otherwise defined, the terms (including technical and scientific terms) used herein have the same meaning as commonly understood by one of ordinary skill in the art to which example embodiments belong. It is further understood that terms, such as those defined in commonly used dictionaries, should be interpreted as having a meaning that is, for example, consistent with their meaning in the context of the relevant art and should not be interpreted in an idealized or overly formal sense unless expressly defined otherwise herein.

The terms used herein have been selected as being general in the related technical field; however, there may be other terms depending on the development and/or change of technology, convention, preference of technicians, and so on. Therefore, the terms used herein should not be understood as limiting technical ideas, but should be understood as examples of the terms for describing example embodiments.

Further, in a specific case, a term may be arbitrarily selected by an applicant, and in this case, the detailed meaning thereof is described herein. Therefore, the terms used herein should be understood based on not only the name of the terms, but also the meaning of the terms and the content hereof.

In the following description, various example embodiments of the present disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

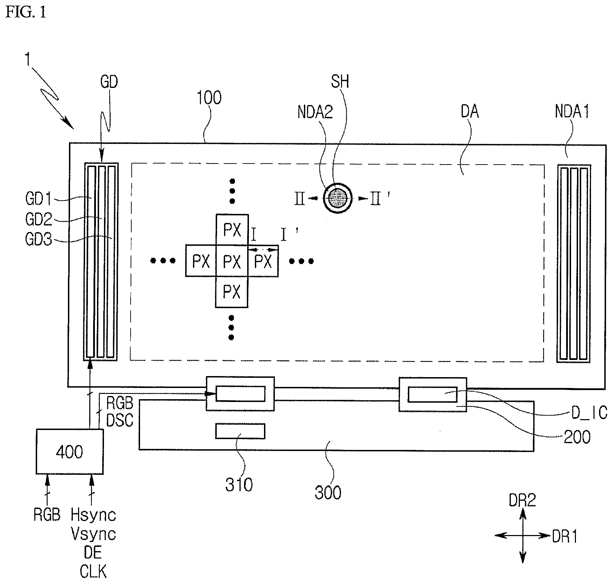

FIG. 1 is a plan view of a display device according to an example embodiment.

Referring to FIG. 1, the display device 1 according to an example embodiment may be an organic light-emitting display device or may be a liquid crystal display device, an inorganic light-emitting display device, or another display device; however, the present disclosure is not limited to the foregoing examples. Hereinafter, for convenience and without limiting the scope of the present disclosure, the organic light-emitting display device is described as the display device according to an example embodiment. The organic light-emitting display device may include a display panel 100. The display panel 100 may include a display area DA, a first non-display area NDA1 positioned at or on the periphery of the display area DA, and a second non-display area NDA2 (or a sensor non-display area) surrounded by the display area DA. The display area DA as well as the non-display areas NDA1 and NDA2 may be defined on or with respect to a substrate 101 described later. Meanwhile, the display panel 100 may further include a sensor hole SH (or a sensor hole area, a hole, a hole area, a through hole, or a through hole area) surrounded by the second non-display area NDA2. The sensor hole SH may be completely surrounded by the second non-display area NDA2 on a plane. A sensor may be disposed in the sensor hole SH. The sensor may be a camera sensor, but may include various sensors in the art, such as an infrared sensor; however, the present disclosure is not limited to the foregoing examples. FIG. 1 illustrates a single sensor hole SH, but there may be a plurality of sensor holes SH; however, the present disclosure is not limited to the foregoing examples.

The display area DA may include a plurality of pixels PX. The plurality of pixels PX may be arranged in a matrix array. The display area DA may be shaped like, but not limited to, a rectangle in which long sides extend along a first direction DR1 and short sides extend along a second direction DR2.

The first non-display area NDA1 may surround the display area DA on a plane. The first non-display area NDA1 may include a pad area. The pad area may be disposed at or on, but not limited to, a second end in the second direction DR2 of the display panel 100.

A chip-on-film (COF) 200 may be attached to the pad area. A driving chip D_IC may be mounted to or on the chip-on-film 200. A printed circuit board 300 may be attached to the second end in the second direction DR2 of the chip-on-film 200. FIG. 1 illustrates that the driving chip D_IC is mounted to the chip-on-film 200, but the present disclosure is not limited thereto. Alternatively, the driving chip D_IC may be directly mounted to the display panel 100. There may be a plurality of chip-on-films 200 arranged along the first direction DR1.

A power management integrated circuit (PMIC) 310, a controller 330, and so on may be mounted on or to the printed circuit board 300. The controller 330 may perform overall control functions related to the operations of the display panel 100, thereby controlling the operations of the driving chip D_IC and the gate driver GD. The PMIC 310 may supply various voltages or currents to the driving chip D_IC, the gate driver GD, and so on, or control various voltages or currents to be supplied. The gate driver GD may be disposed, for example, on or at a first side in the first direction DR1 of the display area DA or on or at the first non-display area NDA1 at a second side in the first direction DR1, but the present disclosure is not limited thereto.

The gate driver GD supplies a scan signal SC to a gate line SL based on a gate control signal GCS transmitted from a controller 330. The gate driver GD may be disposed at one side or opposite sides of the display panel 100 as a gate in panel (GIP) type.

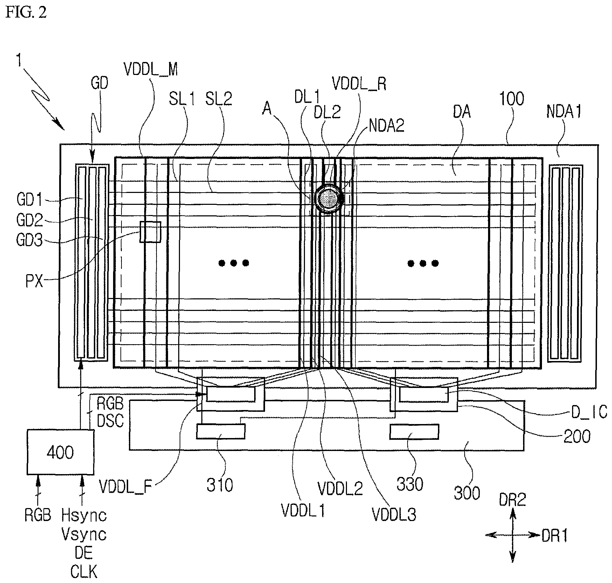

The gate driver GD outputs gate signals to a plurality of gate lines SL1 and SL2 (see FIG. 2) in sequence under the control of the controller 400. The gate driver GD may shift the gate signal through a shift register, thereby sequentially supplying the signals to the gate lines SL1 and SL2 (see FIG. 2).

The gate signal may include a scan signal SC and an emission control signal EM in the organic light-emitting display device. The scan signal SC includes a scan pulse that swings between a gate on voltage VGL and a gate off voltage VGH. The emission control signal may include the emission control signal pulse that swings between a gate on voltage VEL and a gate off voltage VEH.

The scan pulse is synchronized with a data voltage and selects pixels of a line in which data will be written. The emission control signal defines an emission time of the pixels.

The gate driver GD may include an emission control signal driver GD 1, a first scan driver GD2, and a second scan driver GD3.

The emission control signal driver GD1 outputs the emission control signal pulse in response to a start pulse and a shift clock from the controller 400, and sequentially shifts the emission control signal pulses in response to the shift clocks.

The first scan driver GD2 and the second scan driver GD3 outputs the scan pulse in response to the start pulse and the shift clock from the controller 400, and shifts the scan pulse according to the shift clock timing.

Referring to FIG. 1, the emission control signal driver GD 1 may be disposed at the outermost side of the gate driver GD. However, without limiting the scope of the present disclosure, the emission control signal driver GD1 according to an example embodiment may be disposed between the first scan driver GD2 and the second scan driver GD3, or may be disposed between the display panel 100 and the first and second scan drivers GD2 and GD3.

FIG. 2 is a plan view showing an example of high voltage power wirings or lines, data wirings or lines, and scan wirings or lines of the display device of FIG. 1 in detail.

Referring to FIG. 2, the display panel 100 may include the high voltage power wiring, the data wiring, and the scan wiring. Each of the high voltage power wiring, the data wiring, and the scan wiring may be electrically connected to the pixel PX.

The scan wiring may be connected to the gate driver GD and extend along the first direction DR1. The plurality of scan wirings may be arranged in such a configuration that they are spaced apart from each other along the second direction DR2. For example, the plurality of scan wirings may include a first scan wiring or first scan line SL1 and a second scan wiring or second scan line SL2. The first scan wiring SL1 may extend along the first direction DR1 without being bent, whereas the second scan wiring SL2 may extend substantially along the first direction DR1 while bypassing the sensor hole SH in the second non-display area NDA2 on a plane. In the second non-display area NDA2, the second scan wiring SL2 may have a curved shape on a plane.

The data wiring may be connected to the driving chip D_IC and extend along the second direction DR2. The plurality of data wirings may be arranged in such a configuration that they are spaced apart from each other along the first direction DR1. For example, the plurality of data wirings may include a first data wiring or first data line DL1 and a second data wiring or second data line DL2. The first and second data wirings DL1 and DL2 may be sometimes referred to as first and second data lines. The first data wiring DL1 may extend along the second direction DR2 without being bent, whereas the second data wiring DL2 may extend substantially along the second direction DR2 while bypassing the sensor hole SH in the second non-display area NDA2 on a plane. In the second non-display area NDA2, the second data wiring DL2 may have a curved shaped on a plane.

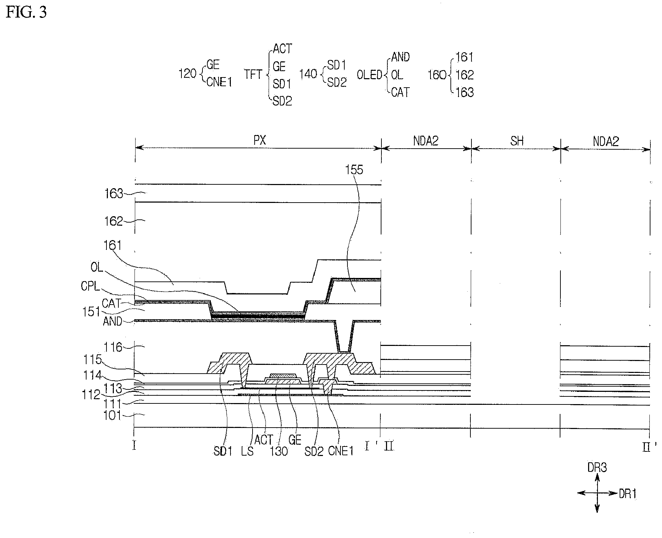

The high voltage power wiring may be connected to the pixel PX, and an organic light-emitting diode (OLED) (see FIG. 3) of the pixel PX may be electrically connected to an anode AND (see FIG. 3).

The high voltage power wiring may, as shown in FIG. 2, include a fan-out power wiring or line VDDL_F, a main power wiring or line VDDL_M, a first power wiring or line VDDL1, a second power wiring or line VDDL2, a third power wiring or line VDDL3, and a hole-surrounding power wiring VDDL_R. The fan-out power wiring VDDL_F may connect the PMIC 310 and the main power wiring VDDL_M. The fan-out power wiring VDDL F may pass the chip-on-film 200. The fan-out power wiring VDDL_F may receive a high-voltage power signal from the PMIC 310 and transmit the signal to the main power wiring VDDL_M. The main power wiring VDDL_M may be disposed in a non-display area NDA. The main power wiring VDDL_M may surround the display area DA on a plane. The main power wiring VDDL_M may completely surround the display area DA on a plane. The power wirings VDDL1, VDDL2, VDDL3, and VDDL_R may connect the main power wiring VDDL_M at the first side in the second direction DR2 and the main power wiring VDDL_M at the second side in the second direction DR2. For example, the first power wiring VDDL1 may directly connect the main power wiring VDDL_M at the first side in the second direction DR2 and the main power wiring VDDL_M at the second side in the second direction DR2. The plurality of first power wirings VDDL1 may extend along the second direction DR2. The plurality of first power wirings VDDL1 may be spaced apart from each other and arranged along the first direction DR1.

Like the first power wiring VDDL1, the second power wiring VDDL2 directly connects the main power wiring VDDL_M at the first side in the second direction DR2 and the main power wiring VDDL_M at the second side in the second direction DR2, and may be in direct contact with the adjacent hole-surrounding power wiring VDDL_R.

The third power wiring VDDL3 may be connected to the hole-surrounding power wiring VDDL R at both the first end in the second direction DR2 and the second end in the second direction DR2.

The hole-surrounding power wiring VDDL_R may completely surround the sensor hole SH on a plane. The hole-surrounding power wiring VDDL_R may completely surround the second non-display area NDA2 on a plane, and be disposed in the display area DA.

In one or more aspects, the high voltage power wiring does not overlap (and is not disposed in) the second non-display area NDA2. For example, the fan-out power wiring VDDL_F and the main power wiring VDDL_M do not overlap the second non-display area NDA2. For example, the first, second and third power wirings VDDL1, VDDL2, and VDDL3 do not overlap the second non-display area NDA2. For example, the hole-surrounding power wiring VDDL_R does not overlap the second non-display area NDA2. In one or more examples, the power wirings VDDL1, VDDL2, and VDDL3 overlap (and are disposed in) the display area DA. In one or more examples, the hole-surrounding power wirings VDDL R overlap (and are disposed in) the display area DA.

FIG. 3 is an example of a cross-sectional view taken along lines I-I' and II-II' in FIG. 1.

Referring to FIG. 3, the display panel 100 (see FIG. 1) may include the substrate 101, a barrier layer 111 on the substrate 101, a light shielding layer LS on the barrier layer 111, a buffer layer 112 on the light shielding layer LS, a semiconductor layer ACT on the buffer layer 112, a gate insulating layer 113 on the semiconductor layer ACT, a first conductive layer 120 on the gate insulating layer 113, a first interlayer insulating layer 114 on the first conductive layer 120, a second conductive layer 130 on the first interlayer insulating layer 114, a second interlayer insulating layer 115 on the second conductive layer 130, a third conductive layer 140 on the second interlayer insulating layer 115, a planarization layer 116 on the third conductive layer 140, an anode AND on a planarization layer 116, a pixel defining layer 151 on the anode AND, an organic layer OL disposed on the anode AND and inside/on the pixel defining layer 151, a cathode CAT on the organic layer OL, a capping layer CPL on the cathode CAT, and an encapsulation layer 160 on the capping layer CPL.

The substrate 101 may support the layers disposed thereon. The substrate 101 may be disposed across the display area DA, the sensor hole SH, and the non-display areas NDA1 and NDA2. In another example, the substrate 101 is not disposed in the sensor hole SH. The substrate 101 may be made of, for example, a polymer resin or the like insulating material. As an example of the polymer material, there are polyethersulphone (PES), polyacrylate (PA), polyarylate (PAR), polyetherimide (PEI), polyethylene napthalate (PEN), polyethylene terepthalate (PET), polyphenylene sulfide (PPS), polyallylate, polyimide (PI), polycarbonate (PC), cellulose triacetate (CAT), cellulose acetate propionate (CAP), or combinations thereof. The substrate 101 may be a flexible substrate capable of bending, folding, rolling, and so on. The flexible substrate may for example be made of, but not limited to, polyimide (PI). Additionally or alternatively, the substrate 101 may be a rigid substrate made of glass, quartz, another rigid material, or a combination thereof.

The barrier layer 111 may be disposed on the substrate 101. The barrier layer 111 may be disposed across the display area DA and the non-display areas NDA1 and NDA2. The barrier layer 111 may not be disposed in the sensor hole SH. The barrier layer 111 may prevent diffusion of impurity ions and permeation of water or external air.

Although it is not shown, the barrier layer 111 may include a plurality of layers. For example, the barrier layer 111 may include layers in which silicon nitride (SiNx) and silicon oxide (SiOx) are alternately stacked at least once.

The light shielding layer LS may be disposed on the barrier layer 111. The light shielding layer LS may overlap the semiconductor layer ACT in a thickness direction. The light shielding layer LS overlaps the semiconductor layer ACT from the bottom, thereby preventing light from entering the semiconductor layer ACT.

The buffer layer 112 may be disposed on the light shielding layer LS. The buffer layer 112 may be disposed across the display area DA and the non-display areas NDA1 and NDA2. The buffer layer 112 may not be disposed in the sensor hole SH. The buffer layer 112 may prevent the diffusion of impurity ions and permeation of water or external air.

Although it is not shown, the buffer layer 112 may include a plurality of layers. For example, the buffer layer 112 may include layers in which silicon nitride (SiNx) and silicon oxide (SiOx) are alternately stacked at least once.

The semiconductor layer ACT may be disposed on the buffer layer 112. The semiconductor layer ACT may include polycrystalline silicon. The semiconductor layer ACT may include a channel area, a source region and a drain region. Polycrystalline silicon may be formed by crystallizing amorphous silicon. Examples of crystallization may include, but are not limited to, rapid thermal annealing (RTA), solid phase crystallization (SPC), excimer laser annealing (ELA), metal-induced crystallization (MIC), metal induced lateral crystallization (MILC), and sequential lateral solidification (SLS). In some example embodiments, the semiconductor layer ACT may include an oxide semiconductor. The oxide semiconductor may include, for example, a binary compound (ABx), a ternary compound (ABxCy), or a quaternary compound (ABxCyDz), which contains indium, zinc, gallium, tin, titanium, aluminum, hafnium (Hf), zirconium (Zr), magnesium (Mg), and so on.

The gate insulating layer 113 may be disposed on the semiconductor layer ACT. The gate insulating layer 113 is substantially disposed across the display area DA and the non-display areas NDA1 and NDA2, but not disposed in the sensor hole SH. The gate insulating layer 113 may include a gate insulating film having a gate insulating function. The gate insulating layer 113 may include a silicon compound, a metal oxide, and so on. For example, the gate insulating layer 113 may include a silicon oxide, a silicon nitride, a silicon oxynitride, an aluminum oxide, a tantalum oxide, a hafnium oxide, a zirconium oxide, a titanium oxide, and so on. These may be used alone or combined with each other. Although it is illustrated that the gate insulating layer 113 is provided as a single layer, in some cases, the gate insulating layer 113 may be provided as a multi-layered film where films of different materials are stacked.

The first conductive layer 120 may be disposed on the gate insulating layer 113.

According to an example embodiment, the first conductive layer 120 may include a gate electrode GE, and a first electrode of a storage capacitor. The first conductive layer 120 may further include scan wiring or scan lines SL1 and SL2 (see FIG. 2) through which scan signals are transmitted to the gate electrode GE. The gate electrode GE may be disposed to overlap the channel area of the semiconductor layer ACT. Meanwhile, the first conductive layer 120 may further include a first connection electrode CNE1 connected to the light shielding layer LS.

The gate electrode GE, and the first electrode of the storage capacitor may be made of the same material under the same process. For example, the first conductive layer 120 may contain one or more metals selected among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu). Although it is illustrated that the first conductive layer 120 is formed as a single layer, in some cases the first conductive layer 120 may be formed as a multi-layered film. In this case, the multi-layered film of the first conductive layer 120 may be formed as a film where different metals among the metals described above are stacked.

The first interlayer insulating layer 114 may be disposed on the first conductive layer 120. The first interlayer insulating layer 114 may be disposed across the display area DA and the non-display area NDA, but may not be disposed in the sensor hole SH.

The first interlayer insulating layer 114 may insulate the first conductive layer 120 and the second conductive layer 130. The first interlayer insulating layer 114 may be an interlayer insulating film.

The first interlayer insulating layer 114 may include an inorganic insulating material such as a silicon oxide, a silicon nitride, a silicon oxynitride, a hafnium oxide, an aluminum oxide, a titanium oxide, a tantalum oxide, or a zinc oxide, or an organic insulating material such as a polyacrylates resin, an epoxy resin, a phenolic resin, a polyamides resin, a polyimides rein, an unsaturated polyesters resin, a poly phenylenethers resin, a polyphenylenesulfides resin, or a benzocyclobutene (BCB). In the accompanying drawings, the first interlayer insulating layer 114 is illustrated, for example, as a single layer. However, the first interlayer insulating layer 114 may be formed as a multi-layered film where films of different materials are stacked. The foregoing illustrates examples, and the present disclosure is not limited thereto.

The second conductive layer 130 may be disposed on the first interlayer insulating layer 114. The second conductive layer 130 may include the second electrode of the storage capacitor. The second electrode may overlap the first electrode with the first interlayer insulating layer 114 therebetween. In other words, the first electrode and the second electrode may form a storage capacitor Cst that uses the first interlayer insulating layer 114 as a dielectric film. Further, the second conductive layer 130 may include the high voltage power wirings or high voltage power lines VDDL_F, VDDL_M, VDDL1, VDDL2, VDDL3, and VDDL_R. In other words, the high voltage power wirings VDDL_F, VDDL_M, VDDL1, VDDL2, VDDL3, and VDDL_R may be formed as (part of) the second conductive layer 130.

The second conductive layer 130 may include one or more metals selected among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu). According to an example embodiment, the second conductive layer 130 may be made of the same material as the first conductive layer 120 described above.

Although the second conductive layer 130 is illustrated as a single layer, in some cases, the second conductive layer 130 may be formed as a multi-layered film.

The second interlayer insulating layer 115 may be disposed on the second conductive layer 130. The second interlayer insulating layer 115 may insulate the second conductive layer 130 and the third conductive layer 140.

The second interlayer insulating layer 115 may include an inorganic insulating material such as a silicon oxide, a silicon nitride, a silicon oxynitride, a hafnium oxide, an aluminum oxide, a titanium oxide, a tantalum oxide, or a zinc oxide, or an organic insulating material such as a polyacrylates resin, an epoxy resin, a phenolic resin, a polyamides resin, a polyimides rein, an unsaturated polyesters resin, a poly phenylenethers resin, a polyphenylenesulfides resin, or benzocyclobutene (BCB).

The second interlayer insulating layer 115 may be disposed even in the non-display areas NDA1 and NDA2 while substantially covering the second conductive layer 130 of the display area DA. The second interlayer insulating layer 115 may not be disposed in the sensor hole SH.

The third conductive layer 140 may be disposed on the second interlayer insulating layer 115. According to an example embodiment, the third conductive layer 140 may include a first source-drain electrode SD1 and a second source-drain electrode SD2. The first source-drain electrode SD1 may be connected to the source region of the semiconductor layer ACT, and the second source-drain electrode SD2 may be connected to the drain region of the semiconductor layer ACT. The second source-drain electrode SD2 may also be connected to the first connection electrode CNE1 of the first conductive layer 120. The third conductive layer 140 may further include data lines or data wirings, such as the first and second data wirings DL1 and DL2 shown in FIG. 2.

The third conductive layer 140 may include one or more metals selected among aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), and molybdenum (Mo). As shown in the accompanying drawings, the third conductive layer 140 may be a single layer. However, without limiting the scope of the present disclosure, the third conductive layer 140 may be a multi-layered film. For example, the third conductive layer 140 may be formed to have a stacked structure of Ti-Al-Ti, Mo-Al-Mo, Mo-AlGe-Mo, Ti-Cu or the like.

The planarization layer 116 may be disposed on the third conductive layer 140. The planarization layer 116 may include an organic insulating material such as a polyacrylates resin, an epoxy resin, a phenolic resin, a polyamides resin, a polyimides rein, an unsaturated polyesters resin, a poly phenylenethers resin, a polyphenylenesulfides resin, or benzocyclobutene (BCB).

The planarization layer 116 may be disposed in the display area DA, but not disposed in the second non-display area NDA2 and the sensor hole SH.

The anode AND may be disposed on the planarization layer 116. The anode AND may connect to the foregoing source electrode SD2.

The anode AND may include one or more metals selected from among aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), and molybdenum (Mo). The anode AND may be a single layer as shown in the accompanying drawings. However, without limiting the scope of the present disclosure, the anode AND may be a multi-layered film. For example, the anode AND may be formed to have a stacked structure of Ti-Al-Ti, Mo-Al-Mo, Mo-AlGe-Mo, Ti-Cu, and so on.

The pixel defining layer 151 may be disposed on the anode AND. The pixel defining layer 151 may include an opening through which the anode AND is exposed. The pixel defining layer 151 may include the organic insulating material or the inorganic insulating material. According to an example embodiment, the pixel defining layer 151 may include a photoresist, a polyimides resin, an acrylic-based resin, a silicon compound, a polyacrylates resin, or the like material.

The organic layer OL may be disposed on the anode AND inside the opening of the pixel defining layer 151. The organic layer OL is illustrated as disposed only inside the opening of the pixel defining layer 151, but the present disclosure is not limited thereto. The organic layer OL may be disposed extending from the opening of the pixel defining layer 151 up to the top of the pixel defining layer 151.

The organic layer OL may include an organic light-emitting layer, a hole injection-transport layer, and an electron injection-transport layer.

The organic layer OL may be disposed on the display area DA.

The cathode CAT is disposed on the organic layer OL and the pixel defining layer 151. The cathode CAT may be a common electrode disposed across the plurality of pixels PX of the display area DA. The organic layer OL, the anode AND, and the cathode CAT may form the organic light-emitting diode (OLED).

The encapsulation layer 160 may be disposed on the cathode CAT. The encapsulation layer 160 may cover the organic light-emitting diode (OLED). The encapsulation layer 160 may be a stacked film where an inorganic film and an organic film are alternately stacked. For example, the encapsulation layer 160 may include a first inorganic film 161, an organic film 162, and a second inorganic film 163 which are stacked in sequence. The first inorganic film 161, the organic film 162, and the second inorganic film 163 may be disposed throughout the display area DA, may also be disposed even in the second non-display area NDA2, but may not be disposed in the sensor hole SH.

As described above, in one or more aspects, no stacked structure other than the substrate 101 may be disposed above (or at) the sensor hole SH. However, without limiting the scope of the present disclosure, the barrier layer 111 may be disposed above (or at) the sensor hole SH.

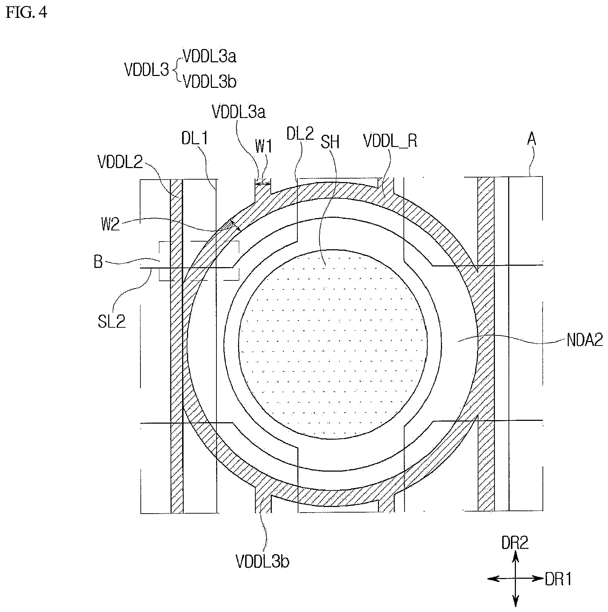

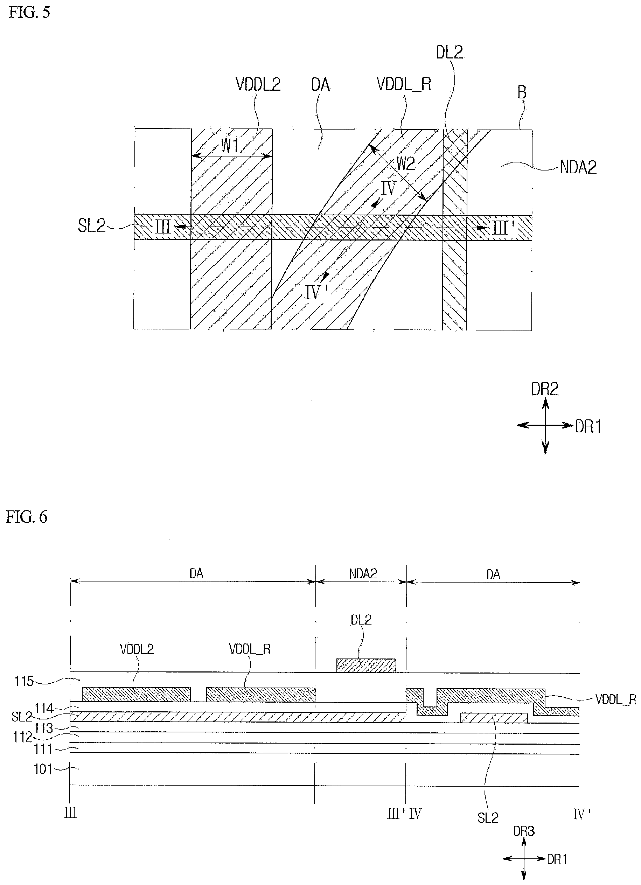

FIG. 4 is an example of an enlarged plan view of an area A in FIG. 2. FIG. 5 is an example of an enlarged plan view of an area B in FIG. 4. FIG. 6 is an example of a cross-sectional view taken along lines III-III' and IV-IV' in FIG. 5.

Referring to FIGS. 4 to 6, the second scan line SL2 may intersect the second power wiring VDDL2 and the hole-surrounding power wiring VDDL_R on a plane, and may also intersect the first and second data lines DL1 and DL2.

The first data line DL1 may intersect the hole-surrounding power wiring VDDL_R and the second scan line SL2 on a plane.

The second data line DL2 may intersect the second scan line SL2 on a plane.

The third power wiring VDDL3 may include a 3-1th (or first) power wiring portion VDDL3a, and a 3-2th (or second) power wiring portion VDDL3b. Each of the 3-1th power wiring portion VDDL3a and the 3-2th power wiring portion VDDL3b may extend along the second direction DR2. The 3-1th power wiring portion VDDL3a may be connected to the first end of the hole-surrounding power wiring VDDL R in the second direction DR2, and the 3-2th power wiring portion VDDL3b may be connected to the second end of the hole-surrounding power wiring VDDL_R in the second direction DR2. In other words, a hole-surrounding power wiring portion VDDL_R may be disposed between the 3-1th power wiring portion VDDL3a and the 3-2th power wiring portion VDDL3b.

In another approach, the hole-surrounding power wiring portion VDDL_R is not disposed around the sensor hole SH, and thus the 3-1th power wiring portion VDDL3a and the 3-2th power wiring portion VDDL3b are physically spaced from each other. The level of high voltage power supplied to the first or second power wirings VDDL1 and VDDL2 formed as a single body may be significantly different from the level of high voltage power supplied to each of the 3-1th power wiring portion VDDL3a and the 3-2th power wiring portion VDDL3b. In this case, the brightness level of light emitted in the pixels PX (see FIG. 2) connected to the 3-1th power wiring portion VDDL3a and the pixels PX (see FIG. 2) and connected to the 3-2th power wiring portion VDDL3b may be significantly different from the brightness level of light emitted in the pixels PX (see FIG. 2) connected to the first or second power wirings VDDL1 or VDDL2, thereby causing nonuniformity in brightness between the pixels PX in the display area DA.

On the other hand, in the case of the display device 1 according to an example embodiment, the hole-surrounding power wiring portion VDDL_R completely surrounding the sensor hole SH on a plane is further disposed between the 3-1th power wiring portion VDDL3a and the 3-2th power wiring portion VDDL3b spaced apart from each other with the sensor hole SH therebetween, the 3-1th power wiring portion VDDL3a is connected to the first end of the hole-surrounding power wiring VDDL_R in the second direction DR2, and the 3-2th power wiring portion VDDL3b is connected to the second end of the hole-surrounding power wiring VDDL_R in the second direction DR2, thereby preventing the nonuniformity in brightness between the pixels within the display area DA.

As shown in FIG. 6, the second scan line SL2 may be disposed in the first conductive layer 120 (see FIG. 3), the third power wiring VDDL3 and the hole-surrounding power wiring VDDL_R may be disposed in the second conductive layer 130 (see FIG. 3), the hole-surrounding power wiring VDDL_R may overlap the second scan line SL2, the second data line DL2 may be disposed in the third conductive layer 140 (see FIG. 3) and overlap the second scan line SL2.

In the display device 1 according to an example embodiment, the width W2 of the hole-surrounding power wiring portion VDDL_R may be the same as the width W1 of the first or second power wirings VDDL1 or VDDL2 and the width W1 of the third power wiring portion VDDL3a and VDDL3b.

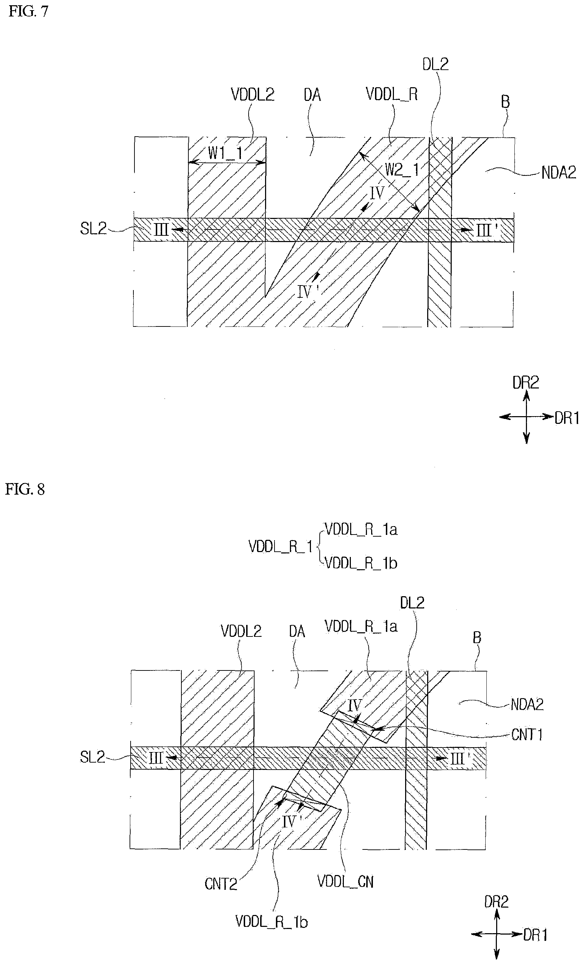

Below, other example embodiments of the display device 1 are described. For example, with respect to FIGS. 7-13, components similar or identical to those of other figures may be designated by like reference numerals. The descriptions provided with respect to FIGS. 7-13 are directed mainly to the characteristics that are different from those of other figures, and the characteristics of the components having like reference numerals may otherwise have similar or identical characteristics as those described with respect to other figures, and thus repetitive descriptions thereof may be applicable to FIGS. 7-13 and are omitted for brevity.

FIG. 7 is a plan view of a display device according to another example embodiment.

The display device of FIG. 7 is different from that of FIG. 5 in that the width W2_1 of the hole-surrounding power wiring portion VDDL_R is different from the width W1_1 of the first or second power wiring VDDL1 or VDDL2 or the width W1_1 of the third power wiring portion VDDL3a and VDDL3b. The cross-sectional view taken along lines III-III' and IV-IV' may be same as for FIG. 5, i.e. as shown in FIG. 6.

In more detail, the width W2_1 of the hole-surrounding power wiring portion VDDL_R may be larger than the width W1_1 of the first or second power wiring VDDL1 or VDDL2 or the width W1_1 of the third power wiring portion VDDL3a and VDDL3b.

According to an example embodiment, the total length of the 3-1th power wiring portion VDDL3a, the hole-surrounding power wiring portion VDDL_R, and the 3-2th power wiring portion VDDL3b may be longer than the length of the first power wiring VDDL1 or the second power wiring VDDL2. Because the hole-surrounding power wiring portion VDDL_R completely surrounds the sensor hole SH, the total length of the 3-1th power wiring portion VDDL3a, the hole-surrounding power wiring VDDL_R, and the 3-2th power wiring portion VDDL3b may be significantly longer than the length of the line of the first or second power wiring VDDL1 or VDDL2.

In this case, there may be a difference in internal resistance between (a) a region representing the 3-1th power wiring portion VDDL3a, the hole-surrounding power wiring VDDL_R, and the 3-2th power wiring portion VDDL3b and (b) a region representing the first or second power wiring VDDL1 or VDDL2. Such a difference in internal resistance between the power wirings may cause nonuniformity in brightness between the pixels PX within the display area DA.

However, in the display device 1 according to an example embodiment illustrated in FIG. 7, the width W2_1 of the hole-surrounding power wiring portion VDDL_R is designed to be larger than the width W1_1 of the first or second power wiring VDDL1 or VDDL2 or the width W1_1 of the third power wiring portion VDDL3a and VDDL3b, thereby reducing a difference in internal resistance between (a) a region representing the 3-1th power wiring portion VDDL3a, the hole-surrounding power wiring VDDL_R, and the 3-2th power wiring portion VDDL3b and (b) a region representing the first or second power wiring VDDL1 or VDDL2. Thus, there is an advantage of preventing nonuniformity in brightness between the pixels PX within the display area DA.

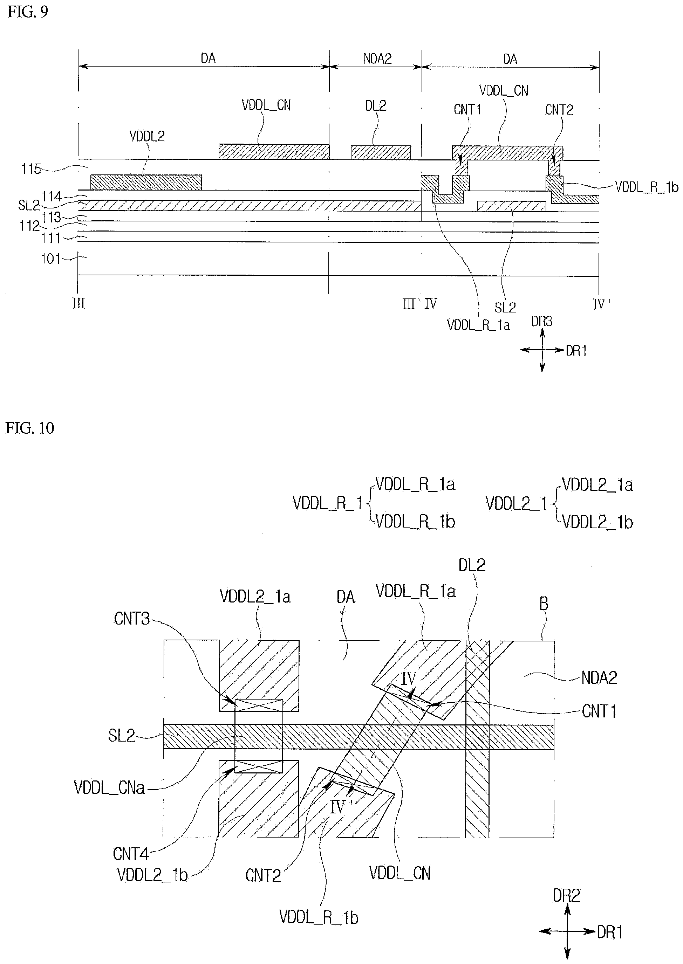

FIG. 8 is a plan view of a display device according to yet another example embodiment. FIG. 9 is an example of a cross-sectional view taken along lines III-III' and IV-IV' in FIG. 8.

The display device shown in FIGS. 8 and 9 is different from that shown in FIG. 5 in that the hole-surrounding power wiring VDDL_R_1 includes a first hole-surrounding power wiring portion VDDL_R_1a, and a second hole-surrounding power wiring portion VDDL_R_1b.

In more detail, the hole-surrounding power wiring VDDL_R_1 may include the first hole-surrounding power wiring portion VDDL_R_1a, and the second hole-surrounding power wiring portion VDDL_R_1b. The first hole-surrounding power wiring portion VDDL_R_1a may be positioned at a first side in the second direction DR2 of the second scan line SL2, and the second hole-surrounding power wiring portion VDDL_R_1b may be positioned at a second side in the second direction DR2 of the second scan line SL2. The first hole-surrounding power wiring portion VDDL_R_1a and the second hole-surrounding power wiring portion VDDL_R_1b may be disposed in such a configuration that they are spaced apart from each other with the second scan line SL2 therebetween on a plane.

The hole-surrounding power wiring VDDL_R_1 may further include a connection wiring portion VDDL_CN. The connection wiring portion VDDL_CN may intersect the second scan line SL2 on a plane. The connection wiring portion VDDL_CN may be disposed in the third conductive layer 140 (see FIG. 3). The connection wiring portion VDDL_CN may be disposed on the same layer as the second data line DL2. The first end of the connection wiring portion VDDL_CN in the second direction DR2 may be connected to the first hole-surrounding power wiring portion VDDL_R_1a through a first contact hole CNT1, and the second end of the connection wiring portion VDDL_CN in the second direction DR2 may be connected to the second hole-surrounding power wiring portion VDDL_R_1b through a second contact hole CNT2. The contact holes CNT1 and CNT2 may be formed by penetrating the second interlayer insulating layer 115.

According to an example embodiment, the connection wiring portion VDDL_CN disposed in the third conductive layer 140 is included in an area where the hole-surrounding power wiring VDDL_R_1 intersects the second scan line SL2, thereby increasing the distance from the second scan line SL2 in a thickness direction as compared with that the first hole-surrounding power wiring portion VDDL_R_1a or the second hole-surrounding power wiring portion VDDL_R_1b is disposed in the intersection area with the second scan line SL2. Thus, there is an advantage of preventing a short circuit between the hole-surrounding power wiring VDDL_R_1 and the second scan line SL2.

The other descriptions are the same as those described above with reference to FIGS. 5 and 6, and thus repetitive descriptions thereof are omitted for brevity.

FIG. 10 is a plan view of a display device according to yet another example embodiment.

The display device shown in FIG. 10 is different from that shown in FIG. 8 in that a second power wiring VDDL2_1 includes a 2-1th power wiring portion VDDL2_1a and a 2-2th power wiring portion VDDL2_1b.

In more detail, the second power wiring VDDL2_1 may include the 2-1th power wiring portion VDDL2_1a, and the 2-2th power wiring portion VDDL2_1b. The 2-1th power wiring portion VDDL2_1a may be positioned at a first side of the second scan line SL2 in the second direction DR2, and the 2-2th power wiring portion VDDL2_1b may be positioned at a second side of the second scan line SL2 in the second direction DR2. The 2-1th power wiring portion VDDL2_1a and the 2-2th power wiring portion VDDL2_1b may be disposed in such a configuration that they are spaced apart from each other with the second scan line SL2 therebetween on a plane.

The second power wiring VDDL2_1 may further include a connection wiring portion VDDL_CNa. The connection wiring portion VDDL_CNa may intersect the second scan line SL2 on a plane. The connection wiring portion VDDL_CNa may be disposed in the third conductive layer 140 (see FIG. 3). The connection wiring portion VDDL_CNa may be disposed in the same layer as the second data line DL2 and the connection wiring portion VDDL_CN. The first end of the connection wiring portion VDDL_CNa in the second direction DR2 may be connected to the 2-1th power wiring portion VDDL2_1a through a third contact hole CNT3, and the second end of the connection wiring portion VDDL_CNa in the second direction DR2 may be connected to the 2-2th power wiring portion VDDL2_1b through a fourth contact hole CNT4. The contact holes CNT3 and CNT4 may be formed by penetrating the second interlayer insulating layer 115.

According to an example embodiment, the connection wiring portion VDDL_CNa disposed in the third conductive layer 140 is included in an area where the second power wiring VDDL2_1 intersects the second scan line SL2, thereby increasing a distance from the second scan line SL2 in a thickness direction as compared with that the 2-1th power wiring portion VDDL2_1a or the 2-2th power wiring portion VDDL2_1b is disposed in the intersection area with the second scan line SL2. Thus, there is an advantage of preventing a short circuit between the second power wiring VDDL2_1 and the second scan line SL2.

The other descriptions are the same as those described above with reference to FIG. 8, and thus repetitive descriptions thereof are omitted for brevity.

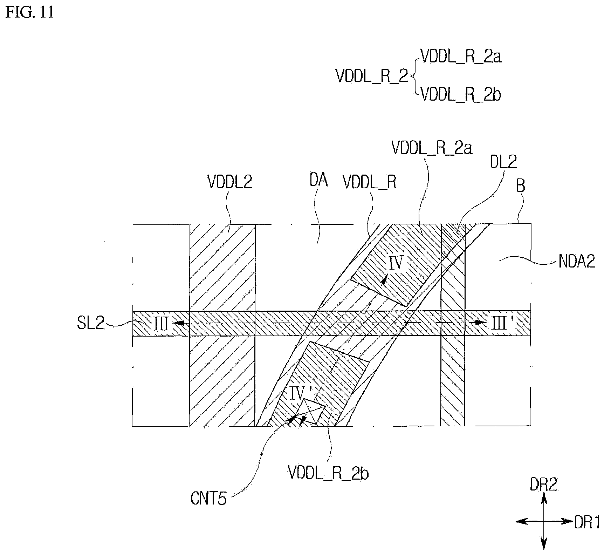

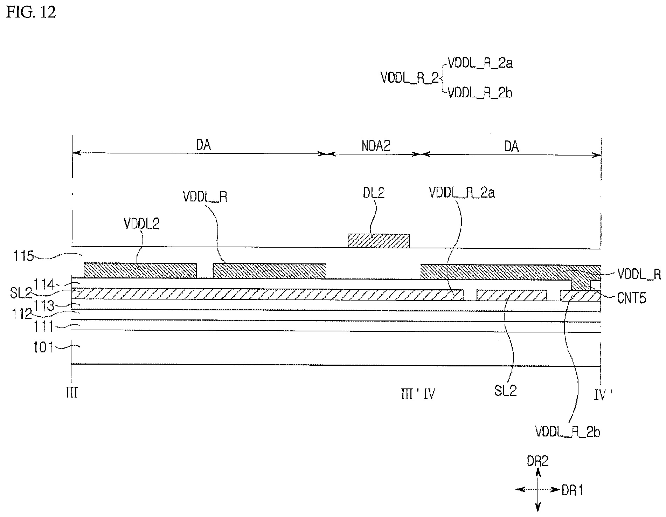

FIG. 11 is a plan view of a display device according to yet another example embodiment. FIG. 12 is an example of a cross-sectional view taken along lines III-III' and IV-IV' in FIG. 11.

The display device according to this example embodiment shown in FIGS. 11 and 12 is different from that shown in FIGS. 8 and 9 in that two or more layers form the hole-surrounding power wiring.

In more detail, the hole-surrounding power wiring according to an example embodiment may include a first hole-surrounding power wiring layer VDDL_R and a second hole-surrounding power wiring layer VDDL_R_2. The first hole-surrounding power wiring layer VDDL_R has the same structure as the hole-surrounding power wiring VDDL_R of FIGS. 8 and 9, and thus repetitive descriptions are omitted for brevity.

The second hole-surrounding power wiring layer VDDL_R_2 may include a 2-1th hole-surrounding power wiring portion VDDL_R_2a, and a 2-2th hole-surrounding power wiring portion VDDL_R_2b. The 2-1th hole-surrounding power wiring portion VDDL_R_2a may be positioned at a first side of the second scan line SL2 in the second direction DR2, and the 2-2th hole-surrounding power wiring portion VDDL_R_2b may be positioned at a second side of the second scan line SL2 in the second direction DR2. The 2-1th hole-surrounding power wiring portion VDDL_R_2a and the 2-2th hole-surrounding power wiring portion VDDL_R_2b may be disposed in such a configuration that they are spaced apart from each other with the second scan line SL2 therebetween on a plane. The 2-1th hole-surrounding power wiring portion VDDL_R_2a and the 2-2th hole-surrounding power wiring portion VDDL_R_2b may be disposed in the same layer as the second scan line SL2. The 2-1th hole-surrounding power wiring portion VDDL _R_2a and the 2-2th hole-surrounding power wiring portion VDDL_R_2b may be electrically connected.

The 2-1th hole-surrounding power wiring portion VDDL_R_2a or the 2-2th hole-surrounding power wiring portion VDDL_R_2b may be connected to the first hole-surrounding power wiring layer VDDL_R through a fifth contact hole CNT5. The fifth contact hole CNT5 may be formed by penetrating the first interlayer insulating layer 114.

According to an example embodiment, the hole-surrounding power wiring includes the first hole-surrounding power wiring layer VDDL_R and the second hole-surrounding power wiring layer VDDL_R_2 disposed in different layers, thereby having an advantage of lowering the resistance of the hole-surrounding power wiring.

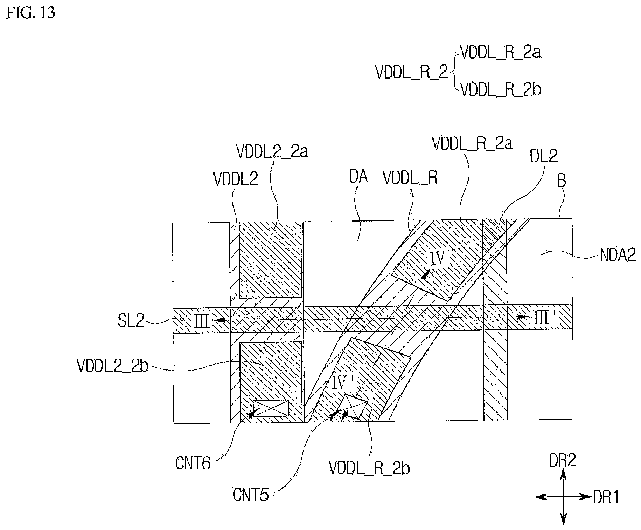

FIG. 13 is a plan view of a display device according to yet another example embodiment.

The display device according to this example embodiment shown in FIG. 13 is different from that shown in FIGS. 11 and 12 in that the second power wiring includes two or more layers.

In more detail, the second power wiring according to an example embodiment may include a first power wiring layer VDDL2 and a second power wiring layer VDDL2_2. The first power wiring layer VDDL2 has the same structure as the second power wiring VDDL2 of FIG. 11, and thus repetitive descriptions thereof are omitted for brevity.

The second power wiring layer VDDL2_2 may include a 2-1th power wiring portion VDDL2_2a, and a 2-2th power wiring portion VDDL2_2b. The 2-1th power wiring portion VDDL2_2a may be positioned at a first side of the second scan line SL2 in the second direction DR2, and the 2-2th power wiring portion VDDL2_2b may be positioned at a second side of the second scan line SL2 in the second direction DR2. The 2-1th power wiring portion VDDL2_2a and the 2-2th power wiring portion VDDL2_2b may be disposed in such a configuration that they are spaced apart from each other with the second scan line SL2 therebetween on a plane. The 2-1th power wiring portion VDDL2_2a and the 2-2th power wiring portion VDDL2_2b may be disposed in the same layer as the second scan line SL2.

The 2-1th power wiring portion VDDL2_2a or the 2-2th power wiring portion VDDL2_2b may be connected to the first power wiring layer VDDL2 through a sixth contact hole CNT6. The sixth contact hole CNT6 may be formed by penetrating the first interlayer insulating layer 114.

According to this example embodiment, the second power wiring includes the first power wiring layer VDDL2 and the second power wiring layer VDDL2_2 disposed in different layers, thereby having an advantage of lowering the resistance of the second power wiring.

Below, cross-sectional views of a display device according to yet other example embodiments are described.

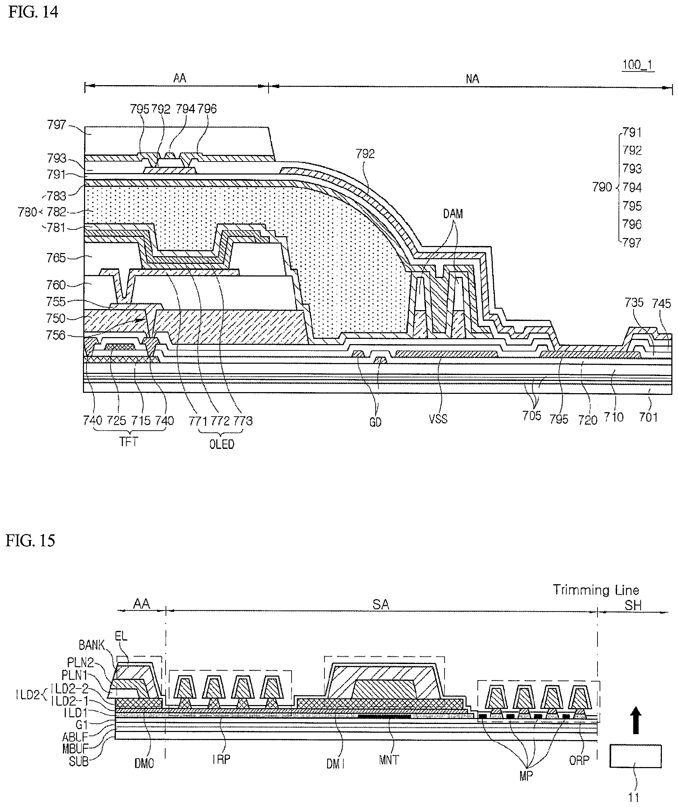

FIG. 14 is a cross-sectional view of a display device according to yet another example embodiment.

Referring to FIG. 14, a thin film transistor TFT for driving a light-emitting diode OLED may be disposed in a display area AA on a substrate 701. The thin film transistor TFT may include a semiconductor layer 715, a gate electrode 725, and source and drain electrodes 740. The thin film transistor TFT may be a driving transistor (DT). For the convenience of description, only the driving transistor (DT) among various thin film transistors included in the display device is illustrated, but other thin film transistors such as a switching transistor may also be included in the display device. Further, the thin film transistor TFT according to one or more example embodiments of the present disclosure has a coplanar structure, but the thin film transistor may be implemented to have other structures such as a staggered structure; however, the present disclosure is not limited to the foregoing examples.

The driving transistor (DT) may adjust the amount of light emitted from the light-emitting diode OLED by controlling the current supplied to the light-emitting diode OLED with a high-potential driving voltage EVDD received in response to a data signal transmitted to the gate electrode 725 of the driving transistor (DT), and maintain the light emission of the light-emitting diode OLED by supplying a constant current with a voltage charged in a storage capacitor (not shown) until receiving the data signal of the next frame. A high-potential supplying line may be formed in parallel with the data line.

As shown in FIG. 14, the thin film transistor TFT may include the semiconductor layer 715 disposed on a first insulating layer 710, the gate electrode 725 overlapping the semiconductor layer 715 with a second insulating layer 720 therebetween, and the source and drain electrodes 740 formed on a third insulating layer 735 and being in contact with the semiconductor layer 715.

The semiconductor layer 715 may be an area where a channel is formed when the thin film transistor TFT is driven. The semiconductor layer 715 may be formed as an oxide semiconductor, formed of various organic semiconductors such as amorphous silicon (a-Si), polycrystalline silicon (poly-Si), and pentacene. The semiconductor layer 715 may be formed on the first insulating layer 710. The semiconductor layer 715 may include the channel area, the source region, and the drain region. The channel area may overlap the gate electrode 725 with the second insulating layer 720 therebetween, thereby forming the channel area between the source and drain electrodes 740. The source region may be electrically connected to the source electrode 740 through the contact hole formed by penetrating the second insulating layer 720 and the third insulating layer 735. The drain region may be electrically connected to the drain electrode 740 through the contact hole formed by penetrating the second insulating layer 720 and the third insulating layer 735. A buffer layer 705 and the first insulating layer 710 may be disposed between the semiconductor layer 715 and the substrate 701. The buffer layer 705 may delay the diffusion of water and-or oxygen permeated into the substrate 701. The first insulating layer 710 may protect the semiconductor layer 715 and block various defects introduced from the substrate 701.

The top layer of the buffer layer 705 being in contact with the first insulating layer 710 may be formed of a material different in etching properties from the other layers of the buffer layer 705, the first insulating layer 710, the second insulating layer 720, and the third insulating layer 735. The top layer of the buffer layer 705 being in contact with the first insulating layer 710 may be formed of one of silicon nitride (SiNx) and silicon oxide (SiOx). The other layers of the buffer layer 705, the first insulating layer 710, the second insulating layer 720, and the third insulating layer 735 may be formed of the other one of silicon nitride (SiNx) and silicon oxide (SiOx). For example, without limiting the scope of the present disclosure, the top layer of the buffer layer 705 being in contact with the first insulating layer 710 may be formed of silicon nitride (SiNx), and the other layers of the buffer layer 705, the first insulating layer 710, the second insulating layer 720, and the third insulating layer 735 may be formed of silicon oxide (SiOx).

The gate electrode 725 may be formed on the second insulating layer 720, and overlap the channel area of the semiconductor layer 715 with the second insulating layer 720 therebetween. The gate electrode 725 may be formed of, but not limited to, a first conductive material as a single layer or a multiple layer, which contains one of magnesium (Mg), molybdenum (Mo), aluminum (Al), chromium (Cr), gold (Au), titanium (Ti), nickel (Ni), neodymium (Nd), and copper (Cu), or an alloy thereof.

The source electrode 740 may be connected to the source region of the semiconductor layer 715 exposed through the contact hole formed by penetrating the second insulating layer 720 and the third insulating layer 735. The drain electrode 740 may face the source electrode 740, and be connected to the drain region of the semiconductor layer 715 through the contact hole formed by penetrating the second insulating layer 720 and the third insulating layer 735. Such source and drain electrodes 740 may be formed of, but not limited to, a second conductive material as a single layer or a multiple layer, which contains one of molybdenum (Mo), aluminum (Al), chromium (Cr), gold (Au), titanium (Ti), nickel (Ni), neodymium (Nd), and copper (Cu), or an alloy thereof.

A connection electrode 755 may be disposed between a first intermediate layer 750 and a second intermediate layer 760. The connection electrode 755 may be exposed through a connection electrode contact hole 756 formed, penetrating a protection film 745 and the first intermediate layer 750 and connected to the drain electrode 740. The connection electrode 755 may be made of, but not limited to, a material having low specific resistivity, which is the same as or similar to the drain electrode 740.

Referring to FIG. 14, the light-emitting diode OLED including a light-emitting layer 772 may be disposed on the second intermediate layer 760 and a bank layer 765. The light-emitting diode OLED may include an anode 771, at least one light-emitting layer 772 formed on the anode 771, and a cathode 773 formed on the light-emitting layer 772.

The anode 771 may be formed on the first intermediate layer 750 through the contact hole formed penetrating the second intermediate layer 760, and electrically connected to the connection electrode 755 exposed to the top of the first intermediate layer 750.

The anode 771 of each pixel is formed to be exposed by the bank layer 765. The bank layer 765 may be formed of an opaque material (e.g., black) to prevent optical interference between adjacent pixels. In this case, the bank layer 765 may include a light shielding material made of, for example, at least one of the color pigments, organic black and carbon. However, the present disclosure is not limited to the foregoing examples.

Referring to FIG. 14, at least one light-emitting layer 772 may be formed on the anode 771 in a light emission area provided by the bank layer 765. The at least one light-emitting layer 772 may include the hole transport layer, the hole injection layer, the hole blocking layer, the light-emitting layer 772, the electron injection layer, the electron blocking layer, the electron transport layer, and so on. on the anode 771, which are stacked in order or in reverse order according to light-emitting directions. Besides, the light-emitting layer 772 may include first and second light-emitting stacks opposite to each other with a charge generating layer therebetween. In this case, the light-emitting layer 772 in one of the first and second light-emitting stacks emits blue light, and the light-emitting layer 772 in the other one of the first and second light-emitting stacks emits yellow-green light, thereby generating white light through the first and second light-emitting stacks. The white light generated in these light-emitting stacks is incident on a color filter positioned above or below the light-emitting layer 772, thereby implementing a color image. Alternatively, colored light may be generated corresponding to each pixel in each light-emitting layer 772 without separate color filters, thereby implementing a color image. For example, the light-emitting layer 772 of a red pixel may generate red light, the light-emitting layer 772 of a green pixel may generate green light, and the light-emitting layer 772 of a blue pixel may generate blue light.

Referring to FIG. 14, the cathode 773 may be formed to face the anode 771 with the light-emitting layer 772 therebetween, and receive the high-potential driving voltage EVDD.

An encapsulation layer 780 prevents external water or oxygen from permeating the light-emitting diode OLED vulnerable to water or oxygen. To this end, the encapsulation layer 780 includes, but is not limited to, at least one inorganic encapsulation layer, and at least one organic encapsulation layer. According to one or more example embodiments of the present disclosure, it is described by way of example that the encapsulation layer 780 has a structure where a first encapsulation layer 781, a second encapsulation layer 782 and a third encapsulation layer 783 are stacked in sequence.

The first encapsulation layer 781 is formed on the substrate 701 formed with the cathode 773. The third encapsulation layer 783 is formed on the substrate 701 formed with the second encapsulation layer 782, and formed to, together with the first encapsulation layer 781, surround the top, bottom and lateral sides of the second encapsulation layer 782. The first encapsulation layer 781 and the third encapsulation layer 783 may minimize or prevent the permeation of external water or oxygen into the light-emitting diode OLED. The first encapsulation layer 781 and the third encapsulation layer 783 may be formed of inorganic insulating materials such as silicon nitride (SiNx), silicon oxide (SiOx), silicon oxynitride (SiON) or aluminum oxide (Al₂O₃) which can be deposited at a low temperature. Because the first encapsulation layer 781 and the third encapsulation layer 783 are deposited at a low temperature atmosphere, the light-emitting diode OLED vulnerable to high temperature atmosphere is prevented from being damaged when the first encapsulation layer 781 and the third encapsulation layer 783 are subjected to a deposition process.

The second encapsulation layer 782 serves as a buffer to relieve stress between the layers due to bending of the display device, and levels out a stepped portion between the layers. The second encapsulation layer 782 may be formed of a non-photosensitive inorganic insulating material such as acryl resin, epoxy resin, phenolic resin, polyamide resin, polyimide resin and polyethylene or silicon oxycarbon (SiOC) or a photosensitive inorganic insulating material such as photo-acryl on the substrate 701 formed with the first encapsulation layer 781, but the present disclosure is not limited thereto. When the second encapsulation layer 782 is formed by an inkjet method, a dam DAM may be disposed to prevent the second encapsulation layer 782 in a liquid state from spreading over to the edges of the substrate 701. The dam DAM may be disposed closer to the edge of the substrate 701 than the second encapsulation layer 782. By the dam DAM, the second encapsulation layer 782 is prevented from spreading to a pad area where a conductive pad disposed at the outmost edge of the substrate 701 is disposed.

The dam DAM is designed to prevent the second encapsulation layer 782 from spreading. However, if the second encapsulation layer 782 is formed beyond the height of the dam DAM during the process, the organic layer, i.e., the second encapsulation layer 782 may be exposed to the outside so that water or the like can easily permeate into the light-emitting diode. Therefore, to prevent this, at least ten dams DAM may be formed to be duplicated.

Referring to FIG. 14, the dam DAM may be disposed on the protection film 745 of the non-display area NA.

Further, the dam DAM may be formed simultaneously with the first intermediate layer 750 and the second intermediate layer 760. A lower layer of the dam DAM may be formed together with the formation of the first intermediate layer 750, and an upper layer of the dam DAM may be formed together with the second intermediate layer 760. Thus, the dam DAM is formed as a dual-stacked structure.

Therefore, the dam DAM may be made of the same material as the first intermediate layer 750 and the second intermediate layer 760, but the present disclosure is not limited thereto.

Still referring to FIG. 14, the dam DAM may be formed overlapping a low-potential driving power line VSS. For example, the low-potential driving power line VSS may be formed as a layer under an area where the dam DAM is positioned within the non-display area NA.

The low-potential driving power line VSS and the gate driver GD formed as a gate in panel (GIP) may be formed to surround the periphery of the display panel, and the low-potential driving power line VSS may be positioned further outside than the gate driver GD. Further, the low-potential driving power line VSS is connected to the anode 771 to supply a common voltage. The gate driver GD is simply illustrated in the cross-sectional view, but may be configured with the thin film transistor TFT having the same structure as the thin film transistor TFT of the display area AA.

Still referring to FIG. 14, the low-potential driving power line VSS is disposed further outside than the gate driver GD. The low-potential driving power line VSS is disposed outside the gate driver GD, and surrounds the display area AA. The low-potential driving power line VSS may be made of the same material as the source and drain electrodes 740 of the thin film transistor TFT, but the present disclosure is not limited thereto. For example, the low-potential driving power line VSS may be made of the same material as the gate electrode 725.

Further, the low-potential driving power line VSS may be electrically connected to the anode 771. The low-potential driving power line VSS may supply a low-potential driving voltage EVSS to the plurality of pixels within the display area AA.

A touch layer 790 may be disposed on the encapsulation layer 780. In the touch layer 790, a touch buffer layer 791 may be positioned between the cathode 773 of the light-emitting diode OLED and touch sensor metal including touch electrode connection lines 792 and 794 and touch electrodes 795 and 796.

The touch buffer layer 791 may block permeation of a chemical solution (e.g., a development solution of an etching solution) used in the process of fabricating the touch sensor metal disposed on the touch buffer layer 791, water from the outside, and so on, into the light-emitting layer 772 including the organic material. Thus, the touch buffer layer 791 prevents the light-emitting layer 772 vulnerable to the chemical solution or water from being damaged.

The touch buffer layer 791 is formed of an organic insulating material, which can be formed at a low temperature below a certain temperature (e.g., 100 degrees Celsius (°C)) and has a low dielectric constant of 1 to 3, to prevent the light-emitting layer 772 including an organic material vulnerable to high temperature from being damaged. For example, the touch buffer layer 791 may be formed of an acrylic-based, epoxy-based, or siloxane-based material. The touch buffer layer 791, which is an organic insulating material and has planarization performance, may prevent the encapsulation layer 780 from being damaged and the touch sensor metal formed on the touch buffer layer 791 from being broken due to the bending of the organic light-emitting display device.

In the touch sensor structure based on mutual capacitance, the touch electrodes 795 and 796 may be disposed on the touch buffer layer 791, and the touch electrodes 795 and 796 may be disposed to intersect each other.

The touch electrode connection lines 792 and 794 may electrically connect the touch electrodes 795 and 796. The touch electrode connection lines 792 and 794 and the touch electrodes 795 and 796 may be positioned at different layers with a touch-insulating film 793 therebetween.

The touch electrode connection lines 792 and 794 are disposed to overlap the bank layer 765 and prevent an aperture from being lowered.

Meanwhile, in the touch electrodes 795 and 796, a part of the touch electrode connection line 792 may be electrically connected to a touch driving circuit (not shown) through a touch pad 198 via a touch pad 198 via the top and lateral side of the encapsulation layer 780 and the top and lateral side of the dam DAM.

The part of the touch electrode connection line 792 may receive a touch driving signal from a touch driving circuit and transmit the touch driving signal to the touch electrodes 795 and 796, and may also transmit a touch sensing signal from the touch electrodes 795 and 796 to the touch driving circuit.

A touch protection film 797 may be disposed on the touch electrodes 795 and 796. In the accompanying drawings, the touch protection film 797 is disposed only on the touch electrodes 795 and 796, but the present disclosure is not limited thereto. Alternatively, the touch protection film 797 may also be disposed on the touch electrode connection line 792, and may extend even to the front or rear of the dam DAM.

In addition, a color filter (not shown) may further be disposed on the encapsulation layer 780. Alternatively, the color filter may be positioned on the touch layer 790, or may also be positioned between the encapsulation layer 780 and the touch layer 790.

The stacked structures or elements in the cross-sectional view of the foregoing display device of FIG. 14 may be applied to the display device 1 of FIGS. 1 to 3. The stacked structures or elements of the display device of FIG. 14 belong to the same technical field as the display device 1 of FIGS. 1 to 3, and thus combinations therebetween are apparent. In other words, the stacked structures or elements in the cross-sectional view within the non-display area NA of the display device of FIG. 14 may be applied to the first non-display area NDA1 of the display device 1 of FIG. 3, and the stacked structures or elements in the cross-sectional view within the display area AA may be applied to the display area DA of the display device 1 of FIG. 3.

FIG. 15 is a cross-sectional view of a display device according to yet another example embodiment.

Referring to FIG. 15, an optical area OA may include a through hole SH and a peripheral area SA, and the display area AA may be positioned outside the peripheral area SA. The display area AA may correspond to the display area DA of FIG. 3, and the through hole SH may correspond to the sensor hole SH of FIG. 3, and the peripheral area SA may correspond to the second non-display area NDA2 of FIG. 3.

In the through hole SH, an optical electronic device 11 may be positioned below the display panel and at least partially overlap the through hole SH.

Referring to FIG. 15, the display device according to one or more example embodiments may include a "dam structure" such as an outer dam DMO positioned in the display area AA, and an inner dam (DMI) positioned in the peripheral area SA. Such a dam structure may include a triple-layered structure formed perpendicularly to a substrate SUB. For example, the dam structure may include a first layer formed as a planarization layer PLN, a second layer formed as a bank, and a third layer formed as a spacer (not shown).

Referring to FIG. 15, a first planarization layer PLN1 and a second planarization layer PLN2 may be included in the planarization layer PLN described above. In such a dam structure, at least a portion of a light-emitting layer EL may be positioned on a spacer.

Some elements of the light-emitting diode may be stacked on the inner dam DMI. For example, the light-emitting layer EL and the common electrode (not shown) may be stacked by climbing over the inner dam DMI.

The concavo-convex pattern RP may be positioned inside and outside such an inner dam DMI. The concavo-convex pattern RP may include a mountain including insulating layers ILD1, ILD2-1, ILD2-2, and a valley where at least some of the insulating layers are removed.

The light-emitting layer EL may be positioned in at least some areas on the concavo-convex pattern RP. The light-emitting layer EL may include the organic light-emitting layer including the organic material. The light-emitting layer EL may extend from the display area AA to at least a portion of the peripheral area SA.

Still referring to FIG. 15, the light-emitting layer EL is discontinuously positioned in an inner concavo-convex pattern IRP and an outer concavo-convex pattern ORP. Accordingly, even though moisture introduced from the through hole SH is permeated into the light-emitting layer EL positioned in the peripheral area SA, the moisture does not permeate up to the light-emitting layer EL positioned in the display area AA. In other words, the light-emitting layer EL is discontinuously present in the concavo-convex pattern RP, thereby having an effect on lengthening a moisture permeation path and an effect on preventing moisture introduced into the light-emitting layer EL from diffusing up to the display area AA.

Meanwhile, referring to FIG. 15, the inner concavo-convex pattern IRP and the outer concavo-convex pattern ORP may be different in the height of the mounting. The height of the mounting in the inner concavo-convex pattern IRP may be higher than the height of the mounting in the outer concavo-convex pattern ORP.

The inner concavo-convex pattern IRP and the outer concavo-convex pattern ORP are different in the height of the mountain because the interlayer insulating films ILD1, ILD2-1, and ILD2-2 included in the mountain are different in the inner concavo-convex pattern IRP and the outer concavo-convex pattern ORP.

For example, referring to FIG. 15, the mountain of the inner concavo-convex pattern IRP may include a 2-2th interlayer insulating film ILD2-2, and may not include a 2-1th interlayer insulating film ILD2-1 and a first interlayer insulating film ILD1. The mountain of the outer concavo-convex pattern ORP may include a 2-1th interlayer insulating film ILD2-1 and a first interlayer insulating film ILD 1, and may not include a 2-2th interlayer insulating film ILD2-2.

Meanwhile, referring to FIG. 15, the bottom of the valley positioned in the outer concavo-convex pattern ORP may be positioned below the bottom of the valley positioned in the inner concavo-convex pattern IRP.

For example, the valley in the outer concavo-convex pattern ORP may be formed by removing at least a portion (e.g., the 2-1th interlayer insulating film ILD2-1) of the first interlayer insulating film ILD1 and the second interlayer insulating film ILD2.

Referring to FIG. 15, while the valley of the concavo-convex pattern RP is formed by removing the first interlayer insulating film ILD1 from the outer concavo-convex pattern ORP, a gate insulating film G1 may be damaged, or insulating films (e.g., ABUF, MBUF, and so on) positioned below the gate insulating film G1 may be damaged.

Thus, a metal pattern (MP) may be positioned in the valley positioned in the outer concavo-convex pattern ORP.

Referring to FIG. 15, the metal pattern MP may, for example, be disposed in the peripheral area SA, having the same shape as the valley positioned in the outer concavo-convex pattern ORP. The metal pattern MP positioned corresponding to the valley of the concavo-convex pattern RP may function as an "etching stopper."

Alternatively, the metal pattern MP may be positioned overlapping the mountain positioned in the outer concavo-convex pattern ORP. In other words, the metal pattern MP may be widely positioned below the outer concavo-convex pattern ORP. In this case, the metal pattern MP may also function to prevent microcracks generated in the through hole SH from extending up to the display area AA. In this case, the metal pattern MP may function as the etching stopper and the crack stopper.

The metal pattern MP may be positioned on the gate-insulating film G1. The metal pattern MP may be formed of the same material as the gate electrode GE of the thin film transistor TFT of FIG. 3 described above.

The metal pattern MP may be made of a material different from that of the insulating films (e.g., the gate insulating film G1, and the first interlayer insulating film II,D1) positioned above and below the metal pattern MP. Therefore, even though the insulating film (e.g., the first interlayer insulating film ILD1) covering the metal pattern MP is removed in an etching process or the like, the insulating film (e.g., the gate insulating film G1) positioned below the metal pattern MP is protected.

Meanwhile, an alignment mark MNT may be positioned in the peripheral area SA. The alignment mark MNT may also be referred to as an "alignment key." The alignment mark MNT may be disposed on a substrate SUB to form the through hole SH by etching a predetermined area from the substrate SUB.

The alignment mark MNT may be disposed in the peripheral area SA in the form of a shape corresponding to the shape of the through hole SH, or may be disposed around the through hole SH in the form of a shape different from the shape of the through hole SH. For example, the alignment mark MNT may be positioned only in some areas among the upper, lower, left, and right areas of the through hole SH.

Meanwhile, the alignment mark MNT may be positioned on the same layer as the metal pattern MP. For example, the alignment mark MNT may be formed of the same material as the gate electrode GE. The alignment mark MNT may be positioned on the gate insulating film G1. The alignment mark MNT may be positioned and be covered with the first interlayer insulating film ILD1.

For example, the alignment mark MNT may be positioned in an area overlapping the inner dam DMI. For example, the alignment mark MNT may be positioned between the inner concavo-convex pattern IRP and the outer concavo-convex pattern ORP.

The stacked structures or elements in the cross-sectional view of the foregoing display device of FIG. 15 may be applied to the display device 1 of FIGS. 1 to 3. The stacked structures or elements of the display device of FIG. 15 belong to the same technical field as the display device 1 of FIGS. 1 to 3, and thus combinations therebetween are apparent. In other words, the stacked structures or elements in the cross-sectional view within the peripheral area SA of the display device of FIG. 15 may be applied to the second non-display area NDA2 of the display device 1 of FIG. 3, and the stacked structures or elements in the cross-sectional view within the display area AA may be applied to the display area DA of the display device 1 of FIG. 3.

In one or more aspects, power wiring may be sometimes referred to as high voltage power wiring, and vice versa. In one or more examples, high voltage power wiring may be configured to be coupled directly or indirectly to a positive power supply terminal when the power supply provides a positive voltage terminal and ground, or to a negative power supply terminal when the power supply provides a negative voltage terminal and ground. In one or more examples, a high voltage or a high voltage power may represent a voltage or a voltage power that is greater than zero in magnitude or that is relatively high in magnitude (compared to other voltages utilized in a display device). In an example, when ground is used as a high voltage, high voltage power wiring may be configured to be coupled directly or indirectly to such ground. A high voltage or a high voltage power may be a positive voltage or a negative voltage or may be a positive voltage power or a negative voltage power. In one or more examples for pixels including n-p-n bipolar junction transistors (BJT) or n-type metal oxide semiconductor field effect transistors (MOSFETs), high voltage power wiring may be configured to receive a voltage representing a common collector voltage (sometimes referred to as VCC), a drain supply voltage (sometimes referred to as VDD), or a high-potential driving voltage (sometimes referred to as EVDD). In one or more examples for pixels including p-n-p BJTs or p-type MOSFETs, high voltage power wiring may be configured to receive a voltage representing a common emitter voltage (sometimes referred to as VEE), a source supply voltage (sometimes referred to as VSS), or a low-potential driving voltage (sometimes referred to as EVSS).

In one or more aspects, a hole-surrounding high voltage power wiring may be sometimes referred to as a hole-surrounding power wiring, and vice versa. In one or more aspects, a connection high voltage power wiring portion may be sometimes referred to as a connection wiring portion, and vice versa. In one or more aspects, a sensor hole area may be sometimes referred to as a hole area or a hole, and vice versa. In one or more aspects, a sensor non-display area may be sometimes referred to as a non-display area or a second non-display area, and vice versa. In one or more aspects, each of a scan wiring and a data wiring may be sometimes referred to as a signal wiring. The scan wiring may include or be a plurality of scan lines. The data wiring may include or be a plurality of data lines.

In one or more aspects, a wiring may be sometime referred to as a line. In one or more examples, wiring may represent a wiring, one or more wirings, or a plurality of wirings. In one or more examples, power wiring may represent a power wiring, one or more power wirings, or a plurality of power wirings. In one or more examples, high voltage power wiring may represent a high voltage power wiring, one or more high voltage power wirings, or a plurality of high voltage power wirings. In one or more examples, a hole-surrounding power wiring may represent one hole-surrounding power wiring, one or more hole-surrounding power wirings, or a plurality of hole-surrounding power wirings. In one or more examples, a signal wiring may represent one signal wiring, one or more signal wirings, or a plurality of signal wirings. In one or more examples, a scan wiring may represent one scan wiring, one or more scan wirings, or a plurality of scan wirings. In one or more examples, a data wiring may represent one data wiring, one or more data wirings, or a plurality of data wirings.

While the present disclosure has been shown and described with reference to one or more example embodiments thereof, it will be understood by a person having ordinary skill in the art to which the disclosure pertains that various modifications and variations in form and details may be made without departing from the scope of the present disclosure. Accordingly, the embodiments described above should be understood to be illustrative and non-limiting in all respects. Further, it is intended that the present disclosure covers the modifications and variations of this disclosure that come within the scope of the claims and their equivalents.

### <EXAMPLE DESCRIPTION OF SOME OF THE REFERENCE NUMERALS>

1: display device
100: display panel
SH: sensor hole
VDDL1, VDDL2, VDDL3: first to third power lines
VDDL_R: hole-surrounding (high-voltage) power wiring

## Claims

1. A display device, comprising:
a substrate (101);
a display area (DA) comprising a plurality of pixels (PX);
a sensor hole area (SH);
a sensor non-display area (NDA2) disposed between the display area (DA) and the sensor hole area (SH);
a first conductive layer (120) disposed on the substrate (101) and comprising a plurality of scan lines (SL1, SL2) connected to the plurality of pixels (PX) and extending in a first direction;
a second conductive layer (130) disposed on the first conductive layer (120) with an insulating layer (114) in between and comprising a plurality of high voltage power lines (VDDL_F, VDDL_M, VDDL1, VDDL2, VDDL3) connected to the plurality of pixels (PX) and extending in a second direction intersecting the first direction; and
a hole-surrounding high voltage power wiring (VDDL_R) surrounding the sensor non-display area (SH) and being connected to at least one of the plurality of high voltage power lines (VDDL_F, VDDL_M, VDDL1, VDDL2, VDDL3).

2. The display device of claim 1, wherein at least a portion of the hole-surrounding high voltage power wiring (VDDL_R) is disposed in the second conductive layer (130).

3. The display device according to any one of the preceding claims, wherein the plurality of high voltage power lines (VDDL_F, VDDL_M, VDDL1, VDDL2, VDDL3) comprises at least one of:
a first power line (VDDL1) extending in the second direction and being spaced apart from the hole-surrounding high voltage power wiring (VDDL_R); and
a second power line (VDDL2) extending in the second direction adjacent to the sensor non-display area (SH), the second power line (VDDL2) being integrally formed with and/or electrically connected to the hole-surrounding high voltage power wiring (VDDL_R).

4. The display device of claim 3, wherein the hole-surrounding high voltage power wiring (VDDL _R) has a larger width than at least one of the plurality of high voltage power lines (VDDL_F, VDDL_M, VDDL1, VDDL2, VDDL3).

5. The display device according to any one of the preceding claims, wherein the plurality of high voltage power lines (VDDL_F, VDDL_M, VDDL1, VDDL2, VDDL3) is disposed in the display area (DA) and/or outside of the sensor non-display area (NDA2) and/or outside of the sensor hole area (SH).

6. The display device according to any one of the preceding claims, wherein at least one of the plurality of scan lines (SL1, SL2) bypasses the sensor hole area (SH) within the sensor non-display area (NDA2) and/or intersects the hole-surrounding high voltage power wiring (VDDL _R).

7. The display device of claim 6, wherein a portion of the hole-surrounding high voltage power wiring (VDDL_R) is disposed in the second conductive layer (130) and/or crosses over said at least one of the plurality of scan lines (SL1, SL2) in the first conductive layer (120) with the insulating layer (114) disposed in between.

8. The display device according to any one of the preceding claims, wherein the plurality of high voltage power lines (VDDL_F, VDDL_M, VDDL1, VDDL2, VDDL3) comprises at least one third power line (VDDL3) extending in the second direction and comprising a first power wiring portion (VDDL3a) and a second power wiring portion (VDDL3b) respectively connected to the hole-surrounding high voltage power wiring (VDDL_R),
wherein the sensor non-display area (NDA2) and/or the sensor hole area (SH) is disposed between the first power wiring portion (VDDL3a) and the second power wiring portion (VDDL3b).

9. The display device according to any one of the preceding claims, further comprising a third conductive layer (140) disposed on the second conductive layer (130) and comprising a plurality of data lines (DL1, DL2) connected to the plurality of pixels (PX) and extending in the second direction.

10. The display device of claim 9, wherein at least one of the plurality of data lines (DL1, DL2) bypasses the sensor hole area (SH) within the sensor non-display area (NDA2) and/or intersects the hole-surrounding high voltage power wiring (VDDL _R).

11. The display device according to any one of the preceding claims, wherein the hole-surrounding high voltage power wiring (VDDL_R) comprises two or more layers, one thereof being the second conductive layer (130).

12. The display device according to any one of claims 9 to 11, wherein the hole-surrounding high voltage power wiring (VDDL_R) comprises a first hole-surrounding high voltage power wiring portion (VDDL_R_1a) and a second hole-surrounding high voltage power wiring portion (VDDL_R_1b) spaced apart from each other in the second conductive layer (130), with one of the scan lines (SL2) disposed between the first and second hole-surrounding high voltage power wiring portions (VDDL_R_1a, VDDL_R_1b).

13. The display device of claim 12 when depending on claim 9, wherein the hole-surrounding high voltage power wiring (VDDL_R) further comprises a connection high voltage power wiring portion (VDDL_CN) disposed in the third conductive layer (140), and the connection high voltage power wiring portion (VDDL_CN) is connected to the first hole-surrounding high voltage power wiring portion (VDDL R 1a) and to the second hole-surrounding high voltage power wiring portion (VDDL_R_1b), and
wherein the connection high voltage power wiring portion (VDDL_CN) crosses one of the plurality of scan lines (SL1, SL2).

14. The display device according to any one of the preceding claims, wherein the hole-surrounding high voltage power wiring comprises a first hole-surrounding high voltage power layer (VDDL_R) disposed in the second conductive layer (130) and a second hole-surrounding high voltage power layer (VDDL_R_2) disposed in the first conductive layer (120), the first hole-surrounding high voltage power layer (VDDL_R) and the second hole-surrounding high voltage power layer (VDDL_R_2) being electrically connected to each other.

15. The display device of claim 14, wherein the second hole-surrounding high voltage power layer (VDDL_R_2) comprises a first hole-surrounding high voltage power wiring portion (VDDL_R_2a) and a second hole-surrounding high voltage power wiring portion (VDDL_R_2b) spaced apart from each other with one of the plurality of scan lines (SL1, SL2) being disposed between the first and second hole-surrounding high voltage power wiring portions (VDDL_R_2a, VDDL_R_2b).
